# EUROPEAN PATENT APPLICATION

(11) **EP 4 773 127 A1**
(43) Date of publication of application: **08.07.2026**
(21) Application number: 25867474.6
(22) Date of filing: 28.04.2025
(51) Int. Cl.: G09G 3/32, G11C 19/28

(54) **SHIFT REGISTER UNIT, DRIVING METHOD THEREFOR, DISPLAY DRIVING CIRCUIT, AND DISPLAY APPARATUS**

(30) Priority: 20.09.2024 WO PCT/CN2024/120140
(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Daxing District Beijing 100176 (CN)
(72) Inventor: WANG, Zhu, Beijing 100176 (CN); HAN, Hongda, Beijing 100176 (CN)
(74) Representative: Isarpatent
(86) International application number: PCT/CN2025/091719
(87) International publication number: WO 2026/060949

(57) **Abstract**

A shift register unit, a driving method of the shift register unit, a display driving circuit and a display device are provided, belonging to the field of display technology. In the shift register unit, an input circuit can transmit power supply signals with different potentials to a control node in different time periods in response to an input signal and clock signals, and two output circuits can both transmit power supply signals with different potentials to connected output terminals in different time periods in response to the potential of the control node. Therefore, it can be determined that the shift register unit comprises both P-type transistors and N-type transistors, and the two output circuits therein can output signals to the connected output terminals independently of each other. On this basis, by flexibly adjusting the potentials of the power supply signals, drive signals with required potentials can be reliably transmitted to pixels in areas with different refresh frequencies through the drive output terminal connected to the pixels, so as to support the partial-refresh function. The shift register unit has a simple structure and rich functions.

## Description

### CROSS-REFERENCE TO RELATED APPLICATION

This application claims the priority of the PCT International Application No. PCT/CN2024/120140 filed on September 20, 2024, the disclosure of which is incorporated herein by reference in its entirety.

### TECHNICAL FIELD

The present disclosure relates to the field of display technologies, and in particular, to a shift register unit, a driving method of the shift register unit, a display driving circuit, and a display device.

### BACKGROUND

In a display device, a Gate Drive on Array (GOA) technology is currently widely used to arrange a display driving circuit for driving pixels to emit light on a substrate; accordingly, the display driving circuit may also be referred to as a GOA circuit. The GOA circuit usually includes a plurality of cascaded shift register units (also referred to as GOA units). A common GOA circuit is a gate driving circuit that transmits gate driving signals to pixels. However, a structure of a current GOA circuit is all relatively complex and has single functions.

### SUMMARY

A shift register unit and a driving method of the shift register unit, a display driving circuit, and a display device are provided. The technical solutions are as follow.

In a first aspect, a shift register unit is provided. The shift register unit includes: an input circuit connected to an input terminal, a first clock terminal, a second clock terminal, a first power supply terminal, a second power supply terminal and a control node, and configured to control on or off between the first power supply terminal and the control node and on or off between the second power supply terminal and the control node in response to an input signal provided by the input terminal, a first clock signal provided by the first clock terminal and a second clock signal provided by the second clock terminal, wherein the first power supply terminal and the second power supply terminal are in a conduction state with the control node in different time periods respectively; a first output circuit connected to the control node, a third power supply terminal, a fourth power supply terminal and a shift output terminal, and configured to control on or off between the third power supply terminal and the shift output terminal and on or off between the fourth power supply terminal and the shift output terminal in response to a potential of the control node, wherein the third power supply terminal and the fourth power supply terminal are in a conduction state with the control node in different time periods respectively; a second output circuit connected to the control node, a fifth power supply terminal, a sixth power supply terminal and a drive output terminal, and configured to control on or off between the fifth power supply terminal and the drive output terminal and on or off between the sixth power supply terminal and the drive output terminal in response to the potential of the control node, wherein the third power supply terminal and the fourth power supply terminal are in a conduction state with the control node in different time periods respectively.

Optionally, the input circuit includes: a first input sub-circuit connected to the input terminal, the first power supply terminal, the second power supply terminal and a first intermediate node respectively, and configured to control on or off between the first power supply terminal and the first intermediate node and on or off between the second power supply terminal and the first intermediate node in response to the input signal, wherein the first power supply terminal and the second power supply terminal are in a conduction state with the first intermediate node in different time periods respectively; a second input sub-circuit connected to the input terminal, the first clock terminal, the second clock terminal, the first intermediate node, the first power supply terminal, the second power supply terminal and the control node, and configured to control on or off between the first intermediate node and the control node in response to the first clock signal, control on or off between the first power supply terminal and the control node in response to the first clock signal and the input signal, and control on or off between the second power supply terminal and the control node in response to the second clock signal and the input signal.

Optionally, the first input sub-circuit includes a first transistor and a second transistor, the first transistor is a first-type transistor, and the second transistor is a second-type transistor; a gate of the first transistor is connected to the input terminal, a first electrode of the first transistor is connected to the first power supply terminal, and a second electrode of the first transistor is connected to the first intermediate node; a gate of the second transistor is connected to the input terminal, a first electrode of the second transistor is connected to the second power supply terminal, and a second electrode of the second transistor is connected to the first intermediate node.

Optionally, the second input sub-circuit includes: a first input unit connected to the first clock terminal, the first power supply terminal and a second intermediate node, and configured to control on or off between the first power supply terminal and the second intermediate node in response to the first clock signal; a second input unit connected to the input terminal, the second power supply terminal and a third intermediate node, and configured to control on or off between the second power supply terminal and the third intermediate node in response to the input signal; a third input unit connected to the first clock terminal, the second clock terminal, the input terminal, the first intermediate node, the second intermediate node, the third intermediate node and the control node, and configured to control on or off between the first intermediate node and the control node in response to the first clock signal, control on or off between the second intermediate node and the control node in response to the input signal, and control on or off between the third intermediate node and the control node in response to the second clock signal.

Optionally, the first input unit includes a third transistor, the second input unit includes a fourth transistor, the third input unit includes a fifth transistor, a sixth transistor and a seventh transistor, and the third transistor, the fifth transistor and the sixth transistor are first-type transistors, and the fourth transistor and the seventh transistor are second-type transistors; a gate of the third transistor is connected to the first clock terminal, a first electrode of the third transistor is connected to the first power supply terminal, and a second electrode of the third transistor is connected to the second intermediate node; a gate of the fourth transistor is connected to the input terminal, a first electrode of the fourth transistor is connected to the second power supply terminal, and a second electrode of the fourth transistor is connected to the third intermediate node; a gate of the fifth transistor is connected to the first clock terminal, a first electrode of the fifth transistor is connected to the first intermediate node, and a second electrode of the fifth transistor is connected to the control node; a gate of the sixth transistor is connected to the input terminal, a first electrode of the sixth transistor is connected to the second intermediate node, and a second electrode of the sixth transistor is connected to the control node; a gate of the seventh transistor is connected to the second clock terminal, a first electrode of the seventh transistor is connected to the third intermediate node, and a second electrode of the seventh transistor is connected to the control node.

Optionally, the first clock terminal is reused as the second clock terminal, and the first clock terminal and the second clock terminal are input with the same clock signal.

Optionally, the first input unit includes a third transistor, the second input unit includes a fourth transistor, the third input unit includes a fifth transistor, a sixth transistor and a seventh transistor, the third transistor, the fifth transistor, the sixth transistor and the seventh transistor are first-type transistors, and the fourth transistor is a second-type transistor; a gate of the third transistor is connected to the first clock terminal, a first electrode of the third transistor is connected to the first power supply terminal, and a second electrode of the third transistor is connected to the second intermediate node; a gate of the fourth transistor is connected to the input terminal, a first electrode of the fourth transistor is connected to the second power supply terminal, and a second electrode of the fourth transistor is connected to the third intermediate node; a gate of the fifth transistor is connected to the first clock terminal, a first electrode of the fifth transistor is connected to the first intermediate node, and a second electrode of the fifth transistor is connected to the control node; a gate of the sixth transistor is connected to the input terminal, a first electrode of the sixth transistor is connected to the second intermediate node, and a second electrode of the sixth transistor is connected to the control node; a gate of the seventh transistor is connected to the first clock terminal, a first electrode of the seventh transistor is connected to the third intermediate node, and a second electrode of the seventh transistor is connected to the control node.

Optionally, the first output circuit includes an eighth transistor and a ninth transistor, the eighth transistor is a first-type transistor, and the ninth transistor is a second-type transistor; a gate of the eighth transistor is connected to the control node, a first electrode of the eighth transistor is connected to the third power supply terminal, and a second electrode of the eighth transistor is connected to the shift output terminal; a gate of the ninth transistor is connected to the control node, a first electrode of the ninth transistor is connected to the fourth power supply terminal, and a second electrode of the ninth transistor is connected to the shift output terminal.

Optionally, the third power supply terminal is commonly used with the first power supply terminal, and/or the fourth power supply terminal is commonly used with the second power supply terminal.

Optionally, the second output circuit includes a tenth transistor and an eleventh transistor, the tenth transistor is a first-type transistor, and the eleventh transistor is a second-type transistor; a gate of the tenth transistor is connected to the control node, a first electrode of the tenth transistor is connected to the fifth power supply terminal, and a second electrode of the tenth transistor is connected to the drive output terminal; a gate of the eleventh transistor is connected to the control node, a first electrode of the eleventh transistor is connected to the sixth power supply terminal, and a second electrode of the eleventh transistor is connected to the drive output terminal.

Optionally, the second output circuit further includes a twelfth transistor connected in series between the fifth power supply terminal and the tenth transistor, and a thirteenth transistor connected in series between the sixth power supply terminal and the eleventh transistor; the twelfth transistor is of the same type as the tenth transistor, and the thirteenth transistor is of the same type as the eleventh transistor; a gate of the twelfth transistor is connected to the control node, a first electrode of the twelfth transistor is connected to the fifth power supply terminal, and a second electrode of the twelfth transistor is connected to a first electrode of the tenth transistor; a gate of the thirteenth transistor is connected to the control node, a first electrode of the thirteenth transistor is connected to the sixth power supply terminal, and a second electrode of the thirteenth transistor is connected to a first electrode of the eleventh transistor.

Optionally, the tenth transistor and the twelfth transistor connected in series have different channel width-to-length ratios; and/or the eleventh transistor and the thirteenth transistor connected in series have different channel width-to-length ratios.

Optionally, the channel width-to-length ratio of the tenth transistor is greater than that of the twelfth transistor; the channel width-to-length ratio of the eleventh transistor is greater than that of the thirteenth transistor.

Optionally, the first power supply terminal to the fourth power supply terminal and the sixth power supply terminal are direct-current power supply terminals, and the fifth power supply terminal is a direct-current supply terminal or an alternate-current supply terminal.

Optionally, the drive output terminal is configured to be connected to pixels in display areas of a display panel for transmitting a drive signal to the pixels to drive the pixels to emit light, and the display areas include a first display area and a second display area, a refresh frequency of the first display area is higher than a refresh frequency of the second display area; when driving the pixels in the first display area to emit light, the potential of a fifth power supply signal provided by the fifth power supply terminal is higher than the potential of the fifth power supply signal provided by the fifth power supply terminal when driving the pixels in the second display area to emit light.

Optionally, when driving the pixels in the second display area to emit light, the potential of the fifth power supply signal provided by the fifth power supply terminal is higher than the potential of the second power supply signal provided by the second power supply terminal.

Optionally, the shift register unit further includes: a drive enhancement circuit connected between the control node and the second output circuit, and configured to transmit the potential of the control node to the second output circuit after performing at least one enhancement process on the potential of the control node.

Optionally, the drive enhancement circuit includes one or more inverters connected in series; each of the one or more inverters includes a fourteenth transistor and a fifteenth transistor connected in series between the first power supply terminal and the second power supply terminal; the fourteenth transistor is a first-type transistor, and the fifteenth transistor is a second-type transistor.

Optionally, the second output circuit is connected to the shift output terminal so as to be connected to the control node through the first output circuit; the second output circuit is configured to control on or off between the fifth power supply terminal and the drive output terminal and the on or off between the sixth power supply terminal and the drive output terminal in response to the potential of the shift output terminal.

Optionally, the second output circuit includes an eighteenth transistor and a nineteenth transistor; a gate of the eighteenth transistor is connected to the shift output terminal, a first electrode of the eighteenth transistor is connected to the fifth power supply terminal, and a second electrode of the eighteenth transistor is connected to the drive output terminal; a gate of the nineteenth transistor is connected to the shift output terminal, a first electrode of the nineteenth transistor is connected to the sixth power supply terminal, and a second electrode of the nineteenth transistor is connected to the drive output terminal.

Optionally, the shift register unit further includes: an output enhancement circuit connected between the shift output terminal and the second output circuit, and configured to transmit the potential of the shift output terminal to the second output circuit after performing at least one enhancement process on the potential of the shift output terminal.

Optionally, the output enhancement circuit includes one or at least two inverters connected in series; each of the one or at least two inverters includes a twentieth transistor and a twenty-first transistor connected in series between the first power supply terminal and the second power supply terminal; the twentieth transistor is a first-type transistor, and the twenty-first transistor is a second-type transistor.

Optionally, the first to fourth power supply terminals and the sixth power supply terminal are all DC power supply terminals, and the fifth power supply terminal is a DC power supply terminal or an AC power supply terminal.

Optionally, the drive output terminal is configured to be connected to pixels in display areas of a display panel for transmitting a drive signal to the pixels to drive the pixels to emit light, and the display areas include a first display area and a second display area, a refresh frequency of the first display area is higher than a refresh frequency of the second display area; when driving the pixels in the first display area to emit light, the potential of a fifth power supply signal provided by the fifth power supply terminal is higher than the potential of the fifth power supply signal provided by the fifth power supply terminal when driving the pixels in the second display area to emit light.

Optionally, when driving the pixels in the second display area to emit light, the potential of the fifth power supply signal provided by the fifth power supply terminal is higher than the potential of a second power supply signal provided by the second power supply terminal.

Optionally, in the shift register unit, the first-type transistor is a P-type transistor, and the second-type transistor is an N-type transistor.

Optionally, the shift register unit further includes a storage capacitor connected between the first power supply terminal and the control node.

Optionally, the shift register unit further includes: a reset circuit connected to a reset signal terminal, the first power supply terminal and the control node, and configured to control on or off between the first power supply terminal and the control node in response to a reset signal provided by the reset signal terminal.

Optionally, the reset circuit includes a sixteenth transistor and a seventeenth transistor; a gate of the sixteenth transistor is connected to the reset signal terminal, a first electrode of the sixteenth transistor is connected to the first power supply terminal, and a second electrode of the sixteenth transistor is connected to a first electrode of the seventeenth transistor; a gate of the seventeenth transistor is connected to the reset signal terminal, and a second electrode of the seventeenth transistor is connected to the control node.

In another aspect, a driving method for a shift register unit, used for driving the shift register unit according to the above aspect, is provided; wherein the method includes: a first phase in which an input circuit controls a first power supply terminal to be in a dis-conduction state with a control node and controls a second power supply terminal to be in a dis-conduction state with the control node in response to an input signal provided by an input terminal, a first clock signal provided by a first clock terminal and a second clock signal provided by a second clock terminal; a first output circuit controls a third power supply terminal to be in a conduction state with a shift output terminal and controls a fourth power supply terminal to be in a dis-conduction state with the shift output terminal in response to the potential of the control node; a second output circuit controls a fifth power supply terminal to be in a conduction state with a drive output terminal and control a sixth power supply terminal to be in a dis-conduction state with the drive output terminal in response to the potential of the control node; a second phase in which the input circuit controls the first power supply terminal to be in a conduction state with the control node and controls the second power supply terminal to be in a dis-conduction state with the control node in response to the input signal, the first clock signal and the second clock signal; the first output circuit controls the third power supply terminal to be in a dis-conduction state with the shift output terminal and controls the fourth power supply terminal to be in a dis-conduction state with the shift output terminal in response to the potential of the control node; the second output circuit controls the fifth power supply terminal to be in a dis-conduction state with the drive output terminal and controls the sixth power supply terminal to be in a conduction state with the drive output terminal in response to the potential of the control node.

Optionally, the first clock terminal is reused as the second clock terminal; the first clock signal provided by the first clock terminal is the same as the second clock signal provided by the second clock terminal.

Optionally, the shift register unit further includes a reset circuit connected to a reset signal terminal, the first power supply terminal and the control node, and configured to control on or off between the first power supply terminal and the control node in response to a reset signal provided by the reset signal terminal; the method includes: a reset phase, in which the reset circuit controls the first power supply terminal to be in a conduction state with the control node in response to a reset signal provided by the reset signal terminal.

In still another aspect, a display driving circuit, including a plurality of cascaded shift register units according the above aspects, is provided.

Optionally, in case that a fifth power supply terminal connected to each of the plurality of shift register units is an alternate current power supply terminal, at least two of the plurality of shift register units are connected to different fifth power supply terminals.

In still yet another aspect, a display device, including a display panel and the display driving circuit according to the above still another aspect, is provided; the display panel includes a plurality of pixels; the display driving circuit is connected to a plurality of pixels through a drive output terminal, and configured to transmit a drive signal to the plurality of pixels to drive the plurality of pixels to emit light.

### BRIEF DESCRIPTION OF THE DRAWINGS

To illustrate the technical solutions in embodiments of the present disclosure more clearly, the accompanying drawings required for describing the embodiments will be briefly introduced below. Obviously, the accompanying drawings in the following description are only some embodiments of the present disclosure. Other drawings can be obtained by those skilled in the art based on these drawings without creative work.
Fig. 1 is a schematic structural diagram of a shift register unit provided in some embodiments of the present disclosure;
Fig. 2 is a schematic structural diagram of another shift register unit provided in some embodiments of the present disclosure;
Fig. 3 is a schematic structural diagram of yet another shift register unit provided in some embodiments of the present disclosure;
Fig. 4 is a schematic structural diagram of still another shift register unit provided in some embodiments of the present disclosure;
Fig. 5 is a schematic circuit structure diagram of a shift register unit provided in some embodiments of the present disclosure;
Fig. 6 is a schematic circuit structure diagram of another shift register unit provided in some embodiments of the present disclosure;
Fig. 7 is a schematic circuit structure diagram of yet another shift register unit provided in some embodiments of the present disclosure;
Fig. 8 is a schematic diagram of partial-refresh division of a shift register unit provided in some embodiments of the present disclosure;
Fig. 9 is a schematic flowchart of a driving method for a shift register unit provided in some embodiments of the present disclosure;
Fig. 10 is a schematic timing diagram of a shift register unit provided in some embodiments of the present disclosure;
Fig. 11 is a schematic timing simulation diagram of a shift register unit provided in some embodiments of the present disclosure;
Fig. 12 is a schematic timing simulation diagram of another shift register unit provided in some embodiments of the present disclosure;
Fig. 13 is a schematic timing simulation diagram of yet another shift register unit provided in some embodiments of the present disclosure;
Fig. 14 is a schematic partial-refresh driving timing diagram of a shift register unit provided in some embodiments of the present disclosure;
Fig. 15 is a schematic structural diagram of a display driving circuit provided in some embodiments of the present disclosure;
Fig. 16 is a schematic structural diagram of another display driving circuit provided in some embodiments of the present disclosure;
Fig. 17 is a schematic structural diagram of yet another display driving circuit provided in some embodiments of the present disclosure;
Fig. 18 is a schematic structural diagram of a display device provided in some embodiments of the present disclosure;
Fig. 19 is a first schematic structural diagram of a shift register unit provided in some embodiments of the present disclosure;
Fig. 20 is a second schematic structural diagram of a shift register unit provided in some embodiments of the present disclosure;
Fig. 21 is a third schematic structural diagram of a shift register unit provided in some embodiments of the present disclosure;
Fig. 22 is a fourth schematic structural diagram of a shift register unit provided in some embodiments of the present disclosure;
Fig. 23 is a schematic circuit structure diagram of a shift register unit provided in some embodiments of the present disclosure;
Fig. 24 is another schematic circuit structure diagram of a shift register unit provided in some embodiments of the present disclosure;
Fig. 25 is a fifth schematic structural diagram of a shift register unit provided in some embodiments of the present disclosure;
Fig. 26 is yet another schematic circuit structure diagram of a shift register unit provided in some embodiments of the present disclosure;
Fig. 27 is a sixth schematic structural diagram of a shift register unit provided in some embodiments of the present disclosure;
Fig. 28 is still another schematic circuit structure diagram of a shift register unit provided in some embodiments of the present disclosure;
Fig. 29 is a schematic timing simulation diagram of a shift register unit provided in some embodiments of the present disclosure;
Fig. 30 is a schematic connection diagram between a shift register unit and a clock signal line provided in some embodiments of the present disclosure;
Fig. 31 is a schematic circuit structure diagram of a shift register unit for partial-refresh provided in some embodiments of the present disclosure;
Fig. 32 is a schematic partial-refresh driving timing diagram of another shift register unit provided in some embodiments of the present disclosure;
Fig. 33 is a schematic partial-refresh division diagram of another shift register unit provided in some embodiments of the present disclosure;
Fig. 34 is a seventh schematic structural diagram of a shift register unit provided in some embodiments of the present disclosure;
Fig. 35 is an eighth schematic structural diagram of a shift register unit provided in some embodiments of the present disclosure;
Fig. 36 is a ninth schematic structural diagram of a shift register unit provided in some embodiments of the present disclosure;
Fig. 37 is a tenth schematic structural diagram of a shift register unit provided in some embodiments of the present disclosure;
Fig. 38 is a schematic circuit structure diagram of a shift register unit provided in some embodiments of the present disclosure;
Fig. 39 is another schematic circuit structure diagram of a shift register unit provided in some embodiments of the present disclosure;
Fig. 40 is an eleventh schematic structural diagram of a shift register unit provided in some embodiments of the present disclosure;
Fig. 41 is yet another schematic circuit structure diagram of a shift register unit provided in some embodiments of the present disclosure;
Fig. 42 is a twelfth schematic structural diagram of a shift register unit provided in some embodiments of the present disclosure;
Fig. 43 is still another schematic circuit structure diagram of a shift register unit provided in some embodiments of the present disclosure;
Fig. 44 is a schematic timing simulation diagram of a shift register unit provided in some embodiments of the present disclosure;
Fig. 45 is still another schematic circuit structure diagram of a shift register unit provided in some embodiments of the present disclosure.

### DETAILED DESCRIPTION

To make the objectives, technical solutions and advantages of the present disclosure clearer, the embodiments of the present disclosure will be described in further detail below with reference to the accompanying drawings.

It should be noted that the transistors adopted in the embodiments of the present disclosure may all be thin film transistors (TFTs), field effect transistors (FETs) or other devices with the same characteristics. The field effect transistors may be, for example, metal-oxide-semiconductor (MOS) field effect transistors, also referred to as MOS transistors. In addition, the transistors adopted in the embodiments of the present disclosure are mainly switching transistors according to their functions in the circuit. Since the source and drain of the switching transistors adopted herein are symmetrical, the source and drain are interchangeable. In the embodiments of the present disclosure, the source may be referred to as the first electrode and the drain as the second electrode. The middle terminal of the transistor is defined as the control electrode (also referred to as the gate) according to the pattern in the drawings, the signal input terminal is the source, and the signal output terminal is the drain. In addition, the switching transistors adopted in the embodiments of the present disclosure may include either P-type transistors or N-type transistors, where a P-type transistor is turned on when the gate is at a low potential and turned off when the gate is at a high potential; an N-type transistor is turned on when the gate is at a high potential and turned off when the gate is at a low potential. In addition, multiple signals in each embodiment of the present application all correspond to a first potential and a second potential. The first potential and the second potential only represent that the potential of the signal has two state quantities, and do not mean that the first potential or the second potential has a specific value throughout the text.

The embodiments of the present application provide a shift register unit with a hybrid CMOS architecture. Through the combination of NMOS and PMOS, it can realize a function of shift output, and is also compatible with a partial-refresh function to support the requirements of partial-refresh driving. It has rich functions, a simple circuit structure and a simple driving principle, which is conducive to the narrow bezel design of display devices. Herein, NMOS refers to N-type MOS transistors, PMOS refers to P-type MOS transistors, and the CMOS architecture refers to an architecture including both NMOS and PMOS.

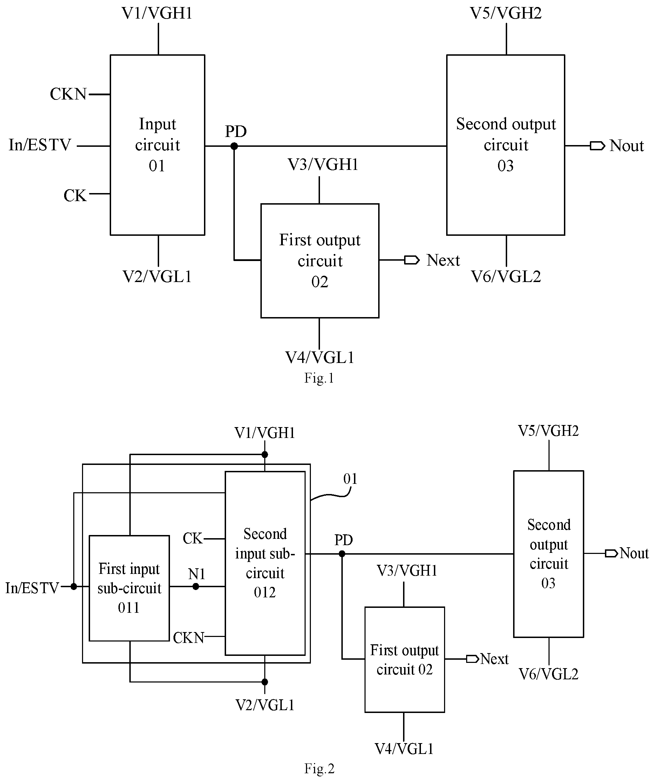

Fig. 1 is a schematic structural diagram of a shift register unit provided in some embodiments of the present disclosure. As shown in Fig. 1, the shift register unit includes an input circuit 01, a first output circuit 02 and a second output circuit 03.

The input circuit 01 is connected to an input terminal In, a first clock terminal CK, a second clock terminal CKN, a first power supply terminal V1, a second power supply terminal V2 and a control node PD, respectively. The input circuit 01 is configured to control on or off between the first power supply terminal V1 and the control node PD and on or off between the second power supply terminal V2 and the control node PD in response to an input signal provided by the input terminal In, a first clock signal provided by the first clock terminal CK and a second clock signal provided by the second clock terminal CKN. In addition, the first power supply terminal V1 and the second power supply terminal V2 are in a conduction state with the control node PD in different time periods, respectively.

Optionally, the first clock signal provided by the first clock terminal CK and the second clock signal provided by the second clock terminal CKN may be inverted clock signals. That is, in the same time period, the potential of the first clock signal and the potential of the second clock signal may be exactly opposite.

On this basis, for example, when the potential of the first clock signal provided by the first clock terminal CK is the first potential and the potential of the second clock signal provided by the second clock terminal CKN is the second potential opposite to the first potential, the input circuit 01 may control the first power supply terminal V1 to be in a conduction state with the control node PD and control the second power supply terminal V2 to be in a dis-conduction state with the control node PD when the potential of the input signal provided by the input terminal In is the first potential, so that the first power supply signal provided by the first power supply terminal V1 can be transmitted to the control node PD; and control the first power supply terminal V1 to be in a dis-conduction state with the control node PD and control the second power supply terminal V2 to be in a conduction state with the control node PD, when the potential of the input signal provided by the input terminal In is the second potential, so that the second power supply signal provided by the second power supply terminal V2 can be transmitted to the control node PD. When the potential of the first clock signal provided by the first clock terminal CK is the second potential and the potential of the second clock signal provided by the second clock terminal CKN is the first potential opposite to the second potential, the input circuit 01 may control both the first power supply terminal V1 and the second power supply terminal V2 to be in a dis-conduction state with the control node PD regardless of whether the potential of the input signal provided by the input terminal In is the first potential or the second potential. That is, the first power supply terminal V1 and the second power supply terminal V2 can be in a conduction state with the control node PD in different time periods, respectively.

Optionally, in the embodiments of the present disclosure, the first potential may be a low potential relative to the second potential. That is, the first potential may be a low potential and the second potential may be a high potential. Moreover, as recorded above, for an N-type transistor, a high potential may be an effective potential and a low potential may be an ineffective potential; for a P-type transistor, a low potential may be an effective potential and a high potential may be an ineffective potential. Certainly, in some other embodiments, the first potential may also be a high potential relative to the second potential. Combined with the above working principle of the input circuit 01 on this basis, it can also be known that the input circuit 01 includes both N-type transistors and P-type transistors.

Optionally, the potential of the first power supply signal provided by the first power supply terminal V1 may be a high potential, and the potential of the second power supply signal provided by the second power supply terminal V2 may be a low potential. Correspondingly, in the embodiments of the present disclosure, the first power supply terminal V1 may also be referred to as a pull-up power supply terminal VGH, and the second power supply terminal V2 may be referred to as a pull-down power supply terminal VGL. In this way, on the basis that the input circuit 01 controls the first power supply terminal V1 and the second power supply terminal V2 to be in a conduction state with the control node PD in different time periods, the potential of the control node PD can be controlled to be a high potential or a low potential in different time periods. Certainly, in some other embodiments, the potential of the first power supply signal provided by the first power supply terminal V1 may also be a low potential, and the potential of the second power supply signal provided by the second power supply terminal V2 may also be a high potential.

The first output circuit 02 is connected to the control node PD, a third power supply terminal V3, a fourth power supply terminal V4 and a shift output terminal NEXT, respectively. The first output circuit 02 is configured to control on or off between the third power supply terminal V3 and the shift output terminal NEXT and the on or off between the fourth power supply terminal V4 and the shift output terminal NEXT in response to the potential of the control node PD. In addition, the third power supply terminal V3 and the fourth power supply terminal V4 are in a conduction state with the control node PD in different time periods, respectively.

For example, the first output circuit 02 may control the third power supply terminal V3 to be in a conduction state with the shift output terminal NEXT and control the fourth power supply terminal V4 to be in a dis-conduction state with the shift output terminal NEXT when the potential of the control node PD is the first potential, so that the third power supply signal provided by the third power supply terminal V3 can be transmitted to the shift output terminal NEXT. The first output circuit 02 may control the third power supply terminal V3 to be in a dis-conduction state with the shift output terminal NEXT and control the fourth power supply terminal V4 to be in a conduction state with the shift output terminal NEXT when the potential of the control node PD is the second potential, so that the fourth power supply signal provided by the fourth power supply terminal V4 can be transmitted to the shift output terminal NEXT. That is, the third power supply terminal V3 and the fourth power supply terminal V4 can be in a conduction state with the shift output terminal NEXT in different time periods, respectively. On this basis, it can also be determined that the first output circuit 02 may also include both N-type transistors and P-type transistors.

Optionally, the potential of the third power supply signal provided by the third power supply terminal V3 may be a high potential, and the potential of the fourth power supply signal provided by the fourth power supply terminal V4 may be a low potential. Correspondingly, in the embodiments of the present disclosure, the third power supply terminal V3 may also be referred to as a pull-up power supply terminal VGH, and the fourth power supply terminal V4 may be referred to as a pull-down power supply terminal VGL. In this way, on the basis that the first output circuit 02 controls the third power supply terminal V3 and the fourth power supply terminal V4 to be in a conduction state with the shift output terminal NEXT in different time periods, shift signals with high and low potentials can be output through the shift output terminal NEXT in different time periods.

Optionally, the shift output terminal NEXT may be used to connect with the input terminal In of other cascaded shift register units to transmit an input signal to the input terminal In of the shift register units of other stages, that is, the shift signal output through the shift output terminal NEXT can be used as an input signal. For the shift register unit of the first stage, as shown in Fig. 1, the input terminal In may be connected to an independent enable signal terminal ESTV to receive an enable signal provided by the enable signal terminal ESTV, and output a shift signal through the shift output terminal NEXT in response to the enable signal, so as to realize cascaded driving.

The second output circuit 03 is connected to the control node PD, a fifth power supply terminal V5, a sixth power supply terminal V6 and a driving output terminal Nout, respectively. The second output circuit 03 is configured to control on or off between the fifth power supply terminal V5 and the driving output terminal Nout and the on or off between the sixth power supply terminal V6 and the driving output terminal Nout in response to the potential of the control node PD. In addition, the third power supply terminal V3 and the fourth power supply terminal V4 are in a conduction state with the control node PD in different time periods, respectively.

For example, the second output circuit 03 may control the fifth power supply terminal V5 to be in a conduction state with the driving output terminal Nout and control the sixth power supply terminal V6 to be in a dis-conduction state with the driving output terminal Nout when the potential of the control node PD is the first potential, so that the fifth power supply signal provided by the fifth power supply terminal V5 can be transmitted to the driving output terminal Nout. The second output circuit 03 may control the fifth power supply terminal V5 to be in a dis-conduction state with the driving output terminal Nout and control the sixth power supply terminal V6 to be in a conduction state with the driving output terminal Nout when the potential of the control node PD is the second potential, so that the sixth power supply signal provided by the sixth power supply terminal V6 can be transmitted to the driving output terminal Nout. That is, the fifth power supply terminal V5 and the sixth power supply terminal V6 can be in a conduction state with the driving output terminal Nout in different time periods, respectively. On this basis, it can also be determined that the second output circuit 03 may also include both N-type transistors and P-type transistors.

Optionally, the potential of the fifth power supply signal provided by the fifth power supply terminal V5 may be a high potential, and the potential of the sixth power supply signal provided by the sixth power supply terminal V6 may be a low potential. Correspondingly, in the embodiments of the present disclosure, the fifth power supply terminal V5 may also be referred to as a pull-up power supply terminal VGH, and the sixth power supply terminal V6 may be referred to as a pull-down power supply terminal VGL. In this way, on the basis that the second output circuit 03 controls the fifth power supply terminal V5 and the sixth power supply terminal V6 to be in a conduction state with the driving output terminal Nout in different time periods, driving signals with high and low potentials can be output through the driving output terminal Nout in different time periods.

Optionally, the driving output terminal Nout may be used to connect with pixels in a display panel to transmit the required driving signals to the pixels, for driving the pixels to emit light. In addition, it may be connected with the pixel circuits in the pixels to control the pixel circuits to drive the light-emitting elements in the pixels to emit light based on the received driving signals.

For example, a display panel may include a plurality of pixels arranged in rows and columns. The driving output terminal Nout of each stage of shift register unit may be connected to the data writing transistors included in the pixel circuit of a row of pixels through a gate line Gate to transmit a gate driving signal to the data writing transistors, so that the data writing transistors control the data line Data to transmit a data signal to the driving transistors in the pixel circuit in response to the gate driving signal, so that the driving transistor drives the light-emitting element to emit light based on the data signal. Multiple stages of shift register units can transmit the gate driving signals to multiple rows of pixels row by row to scan and drive the pixels to emit light row by row, so as to realize scan driving. Correspondingly, the gate driving signal is also referred to as a scan signal. In addition, for the scenario where the potential of the fifth power supply signal provided by the fifth power supply terminal V5 is a high potential and the data writing transistor is an N-type transistor, the gate driving signal may be an N-type gate driving signal GateN required by the N-type data writing transistor. That is, the shift register unit can realize the shift output of GateN. Certainly, the type of the driving signal herein is only a schematic description. For example, in some other embodiments, the driving signal output through the driving output terminal Nout may also be a light-emitting control signal EM transmitted to the light-emitting control transistor in the pixel circuit.

Optionally, in some embodiments, the potential of the fifth power supply signal may include a high potential and a low potential, that is, the fifth power supply terminal V5 may be an AC power supply terminal with an adjustable potential. On this basis, the potential of the fifth power supply signal can be flexibly adjusted according to the different refresh frequency requirements of different areas in the display panel. For example, for a low-frequency refresh area (also referred to as a low-frequency refresh area), the potential of the fifth power supply signal can be controlled to be a low potential, so that the second output circuit 03 outputs a driving signal with a low potential to the pixels in the low-frequency refresh area through the driving output terminal Nout; for a high-frequency refresh area (also referred to as a high-frequency refresh area), the potential of the fifth power supply signal can be controlled to be a high potential, so that the second output circuit 03 outputs a driving signal with a high potential to the pixels in the high-frequency refresh area through the driving output terminal Nout. Thus, the requirements of different refresh frequencies are flexibly met, and a full-screen partial-refresh function (also referred to as a partial-refresh function) is realized, that is, under the control of the shift register unit, different areas in the display panel can display different refresh frequencies, meeting the driving requirements of full-screen partial high-frequency refresh and full-screen partial low-frequency refresh. The low-frequency refresh area and the high-frequency refresh area are relative. For example, the refresh frequency of the low-frequency refresh area may be 1 hertz (Hz), and the refresh frequency of the high-frequency refresh area may be 120 Hz.

It can be seen from the above examples that the shift register unit provided in the embodiments of the present disclosure includes both P-type transistors and N-type transistors. On the basis that the P-type transistors are PMOS and the N-type transistors are NMOS, the shift register unit can be a hybrid CMOS architecture. In addition, in the shift register unit provided in the embodiments of the present disclosure, different output circuits output the required input signals to other stages of shift register units through the shift output terminals Next and output the required driving signals to the pixel circuits through the driving output terminals Nout in response to the potential of the same control node PD, that is, cascaded driving and scan driving can be controlled independently without interfering with each other. Therefore, it can be known that the shift register unit has good output flexibility and reliability, and can reliably drive pixels to emit light while realizing cascaded driving reliably. On this basis, the partial-refresh function can also be supported by flexibly adjusting the potential of the power supply signal provided by the power supply terminal connected to the second output circuit 03, making the shift register unit have rich functions.

In summary, the embodiments of the present application provide a shift register unit. In the shift register unit, the input circuit can transmit power supply signals with different potentials to the control node in different time periods in response to the input signals and the clock signal, and the two output circuits can both transmit power supply signals with different potentials to the connected output terminals in different time periods in response to the potential of the control node. Therefore, it can be determined that the shift register unit includes both P-type transistors and N-type transistors, and the two output circuits can output signals to the connected output terminals independently of each other. On this basis, by flexibly adjusting the potentials of the power supply signals, the driving output terminal connected to the pixels can reliably transmit driving signals with the required potential to the pixels in areas with different refresh frequencies to support the partial-refresh function. The shift register unit has a simple structure and rich functions.

Optionally, Fig. 2 is a schematic structural diagram of another shift register unit provided in some embodiments of the present disclosure. As shown in Fig. 2, the input circuit 01 may include a first input sub-circuit 011 and a second input sub-circuit 012.

The first input sub-circuit 011 may be connected to the input terminal In, the first power supply terminal V1, the second power supply terminal V2 and a first intermediate node N1, respectively. The first input sub-circuit 011 may be configured to control on or off between the first power supply terminal V1 and the first intermediate node N1 and the on or off between the second power supply terminal V2 and the first intermediate node N1 in response to the input signal. In addition, the first power supply terminal V1 and the second power supply terminal V2 may be in a conduction state with the first intermediate node N1 in different time periods, respectively.

For example, the first input sub-circuit 011 may control the first power supply terminal V1 to be in a conduction state with the first intermediate node N1 and control the second power supply terminal V2 to be in a dis-conduction state with the first intermediate node N1 when the potential of the input signal is the first potential, so that the first power supply signal provided by the first power supply terminal V1 can be transmitted to the first intermediate node N1. The first input sub-circuit 011 may control the first power supply terminal V1 to be in a dis-conduction state with the first intermediate node N1 and control the second power supply terminal V2 to be in a conduction state with the first intermediate node N1 when the potential of the input signal is the second potential, so that the second power supply signal provided by the second power supply terminal V2 can be transmitted to the first intermediate node N1. That is, the first power supply terminal V1 and the second power supply terminal V2 can be in a conduction state with the first intermediate node N1 in different time periods, respectively. On this basis, it can also be determined that the first input sub-circuit 011 may include both N-type transistors and P-type transistors.

The second input sub-circuit 012 may be connected to the input terminal In, the first clock terminal CK, the second clock terminal CKN, the first intermediate node N1, the first power supply terminal V1, the second power supply terminal V2 and the control node PD, respectively. The second input sub-circuit 012 may be configured to control on or off between the first intermediate node N1 and the control node PD in response to the first clock signal, control on or off between the first power supply terminal V1 and the control node PD in response to the first clock signal and the input signal, and control on or off between the second power supply terminal V2 and the control node PD in response to the second clock signal and the input signal.

For example, the second input sub-circuit 012 may control the first intermediate node N1 to be in a conduction state with the control node PD when the potential of the first clock signal is the first potential, so that the first power supply signal or the second power supply signal transmitted to the first intermediate node N1 can be further transmitted to the control node PD; and may control the first intermediate node N1 to be in a dis-conduction state with the control node PD when the potential of the first clock signal is the second potential. The second input sub-circuit 012 may control the first power supply terminal V1 to be in a conduction state with the control node PD when the potential of the first clock signal is the first potential and the potential of the input signal is the first potential, so that the first power supply signal provided by the first power supply terminal V1 can be transmitted to the control node PD; and may control the first power supply terminal V1 to be in a dis-conduction state with the control node PD when the potential of the first clock signal and/or the potential of the input signal is the second potential. The second input sub-circuit 012 may control the second power supply terminal V2 to be in a conduction state with the control node PD when the potential of the second clock signal is the second potential and the potential of the input signal is the second potential, so that the second power supply signal provided by the second power supply terminal V2 can be transmitted to the control node PD; and may control the second power supply terminal V2 to be in a dis-conduction state with the control node PD when the potential of the second clock signal and/or the potential of the input signal is the first potential.

In this way, with the cooperation of the first input sub-circuit 011 and the second input sub-circuit 012, the first power supply terminal V1 and the second power supply terminal V2 can be in a conduction state with the control node PD in different time periods, respectively, thereby outputting the first power supply signal with a high potential and the second power supply signal with a low potential to the control node PD in different time periods to control the potential of the control node PD to be a high potential or a low potential.

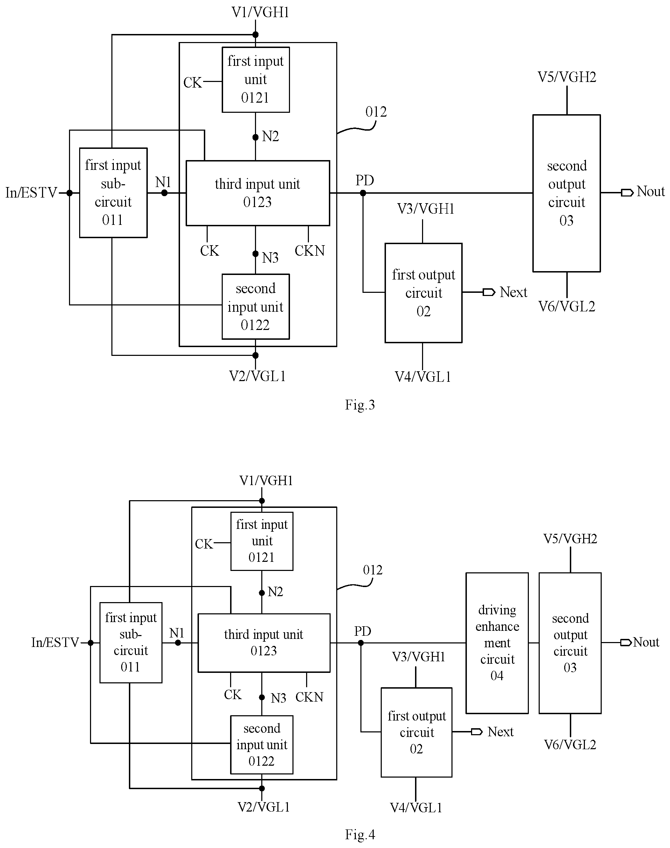

Optionally, Fig. 3 is a schematic structural diagram of yet another shift register unit provided in some embodiments of the present disclosure. As shown in Fig. 3, the second input sub-circuit 012 may include a first input unit 0121, a second input unit 0122 and a third input unit 0123.

The first input unit 0121 may be connected to the first clock terminal CK, the first power supply terminal V1 and the second intermediate node N2, respectively. The first input unit 0121 may be configured to control on or off between the first power supply terminal V1 and the second intermediate node N2 in response to the first clock signal.

For example, the first input unit 0121 may control the first power supply terminal V1 to be in a conduction state with the second intermediate node N2 when the potential of the first clock signal is the first potential, so that the first power supply signal provided by the first power supply terminal V1 can be transmitted to the second intermediate node N2; and may control the first power supply terminal V1 to be in a dis-conduction state with the second intermediate node N2 when the potential of the first clock signal is the second potential.

The second input unit 0122 may be connected to the input terminal In, the second power supply terminal V2 and the third intermediate node N3, respectively. The second input unit 0122 may be configured to control on or off between the second power supply terminal V2 and the third intermediate node N3 in response to the input signal.

For example, the second input unit 0122 may control the second power supply terminal V2 to be in a conduction state with the third intermediate node N3 when the potential of the input signal is the second potential, so that the second power supply signal provided by the second power supply terminal V2 can be transmitted to the third intermediate node N3; and may control the second power supply terminal V2 to be in a dis-conduction state with the third intermediate node N3 when the potential of the input signal is the first potential.

The third input unit 0123 may be connected to the first clock terminal CK, the second clock terminal CKN, the input terminal In, the first intermediate node N1, the second intermediate node N2, the third intermediate node N3 and the control node PD, respectively. The third input unit 0123 may be configured to control on or off between the first intermediate node N1 and the control node PD in response to the first clock signal, control on or off between the second intermediate node N2 and the control node PD in response to the input signal, and control on or off between the third intermediate node N3 and the control node PD in response to the second clock signal.

For example, the third input unit 0123 may control the first intermediate node N1 to be in a conduction state with the control node PD when the potential of the first clock signal is the first potential, so that the first power supply signal or the second power supply signal transmitted to the first intermediate node N1 can be further transmitted to the control node PD; and may control the first intermediate node N1 to be in a dis-conduction state with the control node PD when the potential of the first clock signal is the second potential. The third input unit 0123 may control the second intermediate node N2 to be in a conduction state with the control node PD when the potential of the input signal is the first potential, so that the first power supply signal transmitted to the second intermediate node N2 can be further transmitted to the control node PD; and may control the second intermediate node N2 to be in a dis-conduction state with the control node PD when the potential of the input signal is the second potential. The third input unit 0123 may control the third intermediate node N3 to be in a conduction state with the control node PD when the potential of the second clock signal is the second potential, so that the second power supply signal transmitted to the third intermediate node N3 can be further transmitted to the control node PD; and may control the third intermediate node N3 to be in a dis-conduction state with the control node PD when the potential of the second clock signal is the first potential.

In this way, with the cooperation of the first input unit 0121, the second input unit 0122 and the third input unit 0123, the first power supply terminal V1 and the second power supply terminal V2 can be in a conduction state with the control node PD in different time periods, respectively, thereby outputting the first power supply signal with a high potential and the second power supply signal with a low potential to the control node PD in different time periods to control the potential of the control node PD to be a high potential or a low potential.

Optionally, Fig. 4 is a schematic structural diagram of still another shift register unit provided in some embodiments of the present disclosure. As shown in Fig. 4, the shift register unit may further include a driving enhancement circuit 04.

The driving enhancement circuit 04 may be connected between the control node PD and the second output circuit 03. The driving enhancement circuit 04 may be configured to transmit the potential of the control node PD to the second output circuit 03 after performing at least one enhancement process on the potential of the control node PD. The enhancement process may be, for example, an inversion process. Certainly, to make the potential of the control node PD after the enhancement process the same as that before the enhancement process, the driving enhancement circuit 04 may transmit the potential of the control node PD to the second output circuit 03 after performing an even number of inversion processes on the potential of the control node PD.

It can be understood that the provision of the driving enhancement circuit 04 can achieve the purpose of enhancing the driving capability of the shift register unit, so that the second output circuit 03 can reliably output the required driving signal to the pixel circuit through the driving output terminal Nout in response to the enhanced potential of the control node PD, thereby enabling the pixel circuit to reliably drive the light-emitting element to emit light. Certainly, in some other embodiments, the driving enhancement circuit 04 may also be connected between the control node PD and the first output circuit 02 in the same manner to achieve the same enhancement effect and improve the cascade driving capability of the shift register unit.

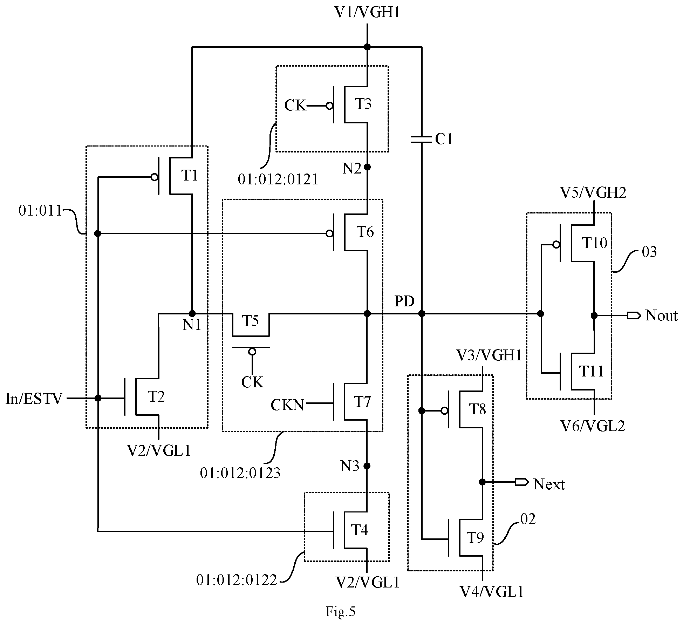

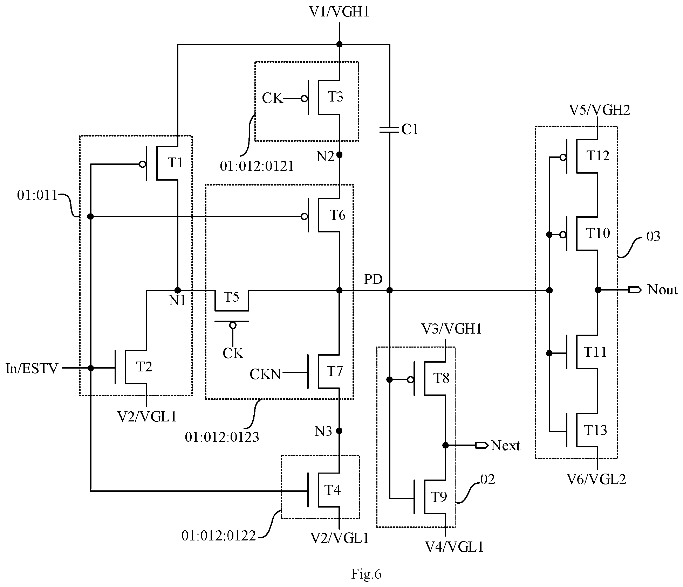

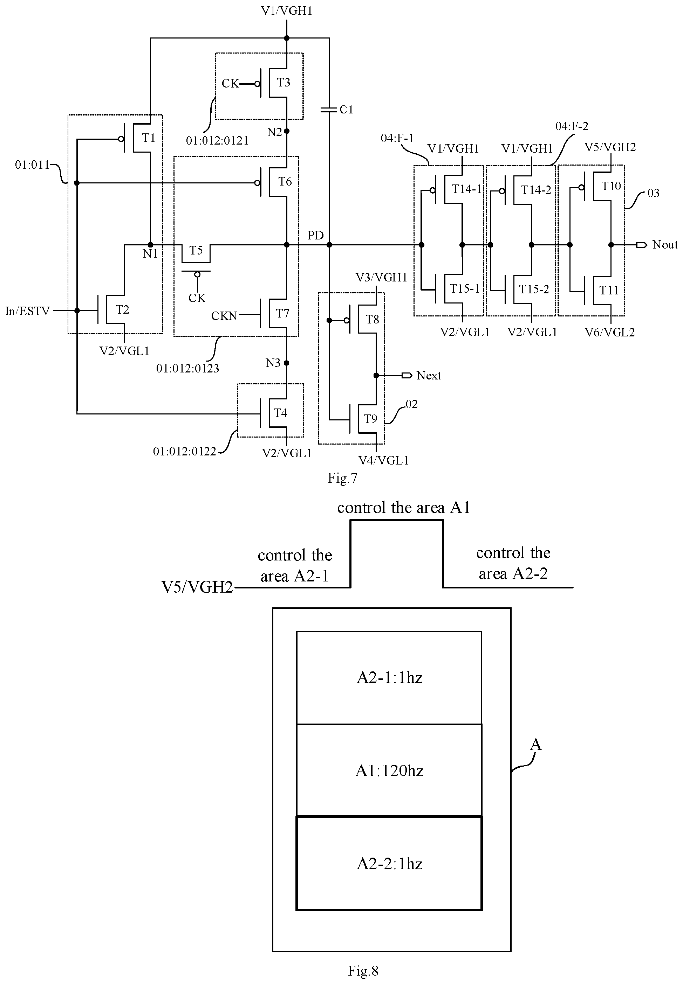

Optionally, on the basis of Fig. 3, Fig. 5 shows a schematic circuit structure diagram of a shift register unit, and Fig. 6 shows a schematic circuit structure diagram of another shift register unit. On the basis of Fig. 4, Fig. 7 shows a schematic circuit structure diagram of yet another shift register unit.

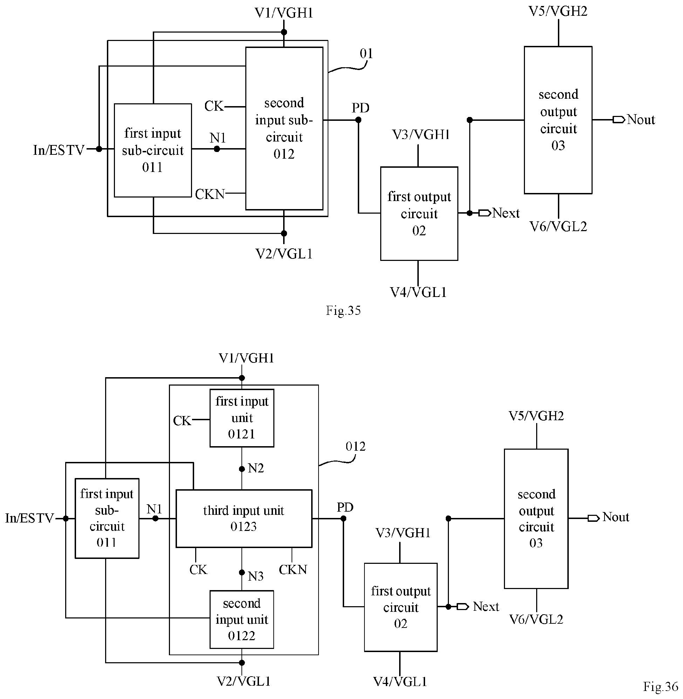

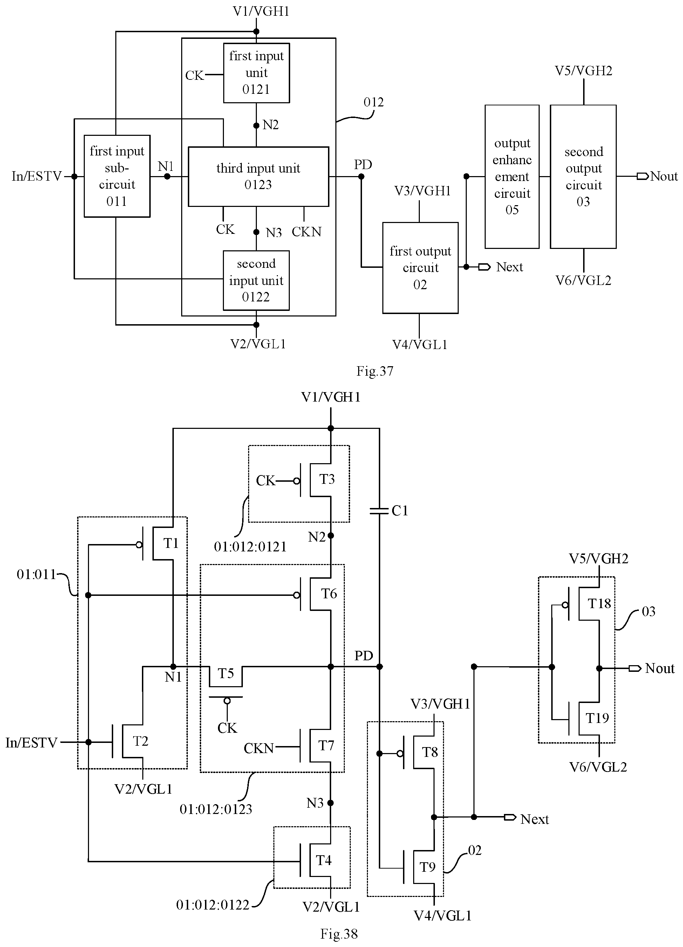

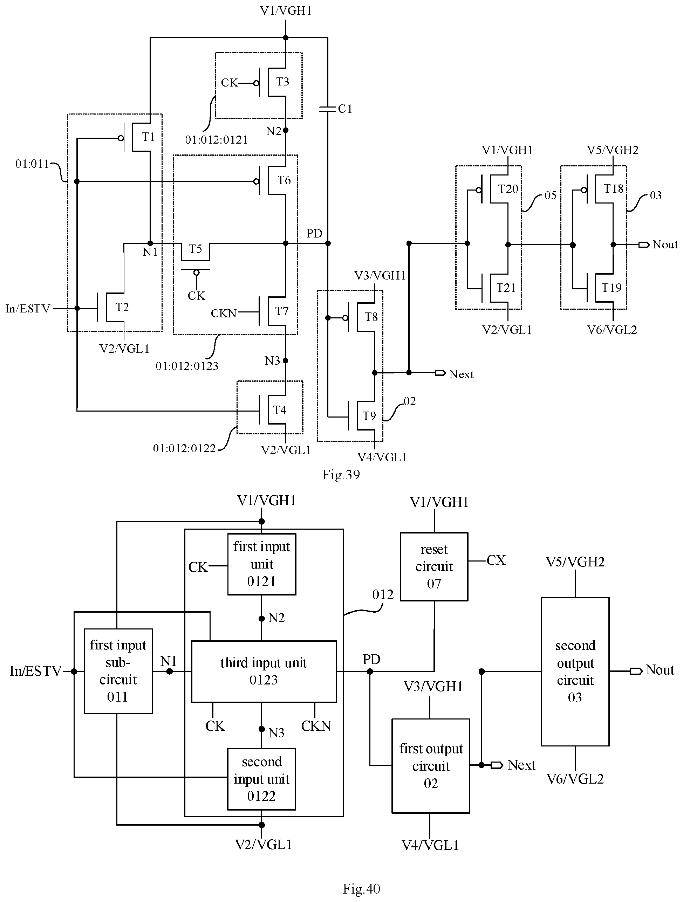

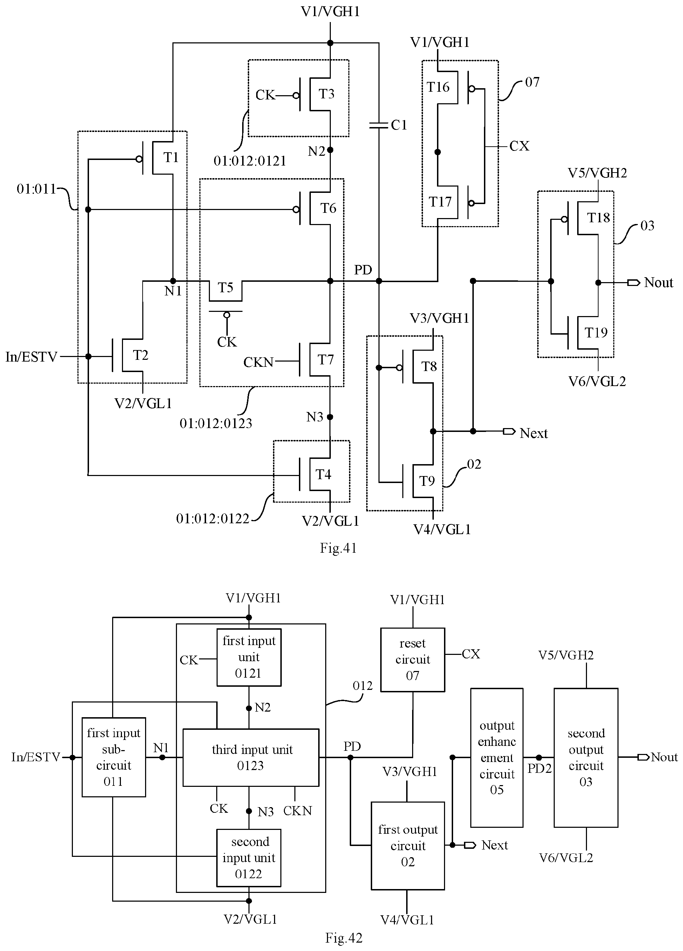

Optionally, referring to Figs. 5 to 7 and Figs. 35 to 43, it can be seen that the first input sub-circuit 011 may include a first transistor T1 and a second transistor T2. In addition, the first transistor T1 may be a first-type transistor, and the second transistor T2 may be a second-type transistor.

The gate of the first transistor T1 may be connected to the input terminal In, the first electrode of the first transistor T1 may be connected to the first power supply terminal V1, and the second electrode of the first transistor T1 may be connected to the first intermediate node N1.

The gate of the second transistor T2 may be connected to the input terminal In, the first electrode of the second transistor T2 may be connected to the second power supply terminal V2, and the second electrode of the second transistor T2 may be connected to the first intermediate node N1.

Optionally, in combination with the above description, one of the first-type transistor and the second-type transistor may be an N-type transistor, and the other may be a P-type transistor. That is, one transistor may be an N-type transistor (e.g., NMOS), and the other may be a P-type transistor (e.g., PMOS).

For example, on the basis that the first potential is a low potential and the second potential is a high potential, the first-type transistor may be a P-type transistor, and the second-type transistor may be an N-type transistor. In some other embodiments, on the basis that the first potential is a high potential and the second potential is a low potential, the first-type transistor may be an N-type transistor, and the second-type transistor may be a P-type transistor.

Optionally, with continued reference to Figs. 5 to 7 and Figs. 35 to 43, it can be seen that the first input unit 0121 may include a third transistor T3, the second input unit 0122 may include a fourth transistor T4, and the third input unit 0123 may include a fifth transistor T5, a sixth transistor T6 and a seventh transistor T7. In addition, the third transistor T3, the fifth transistor T5 and the sixth transistor T6 may be first-type transistors (e.g., P-type transistors), and the fourth transistor T4 and the seventh transistor T7 may be second-type transistors (e.g., N-type transistors).

The gate of the third transistor T3 may be connected to the first clock terminal CK, the first electrode of the third transistor T3 may be connected to the first power supply terminal V1, and the second electrode of the third transistor T3 may be connected to the second intermediate node N2.

The gate of the fourth transistor T4 may be connected to the input terminal In, the first electrode of the fourth transistor T4 may be connected to the second power supply terminal V2, and the second electrode of the fourth transistor T4 may be connected to the third intermediate node N3.

The gate of the fifth transistor T5 may be connected to the first clock terminal CK, the first electrode of the fifth transistor T5 may be connected to the first intermediate node N1, and the second electrode of the fifth transistor T5 may be connected to the control node PD.

The gate of the sixth transistor T6 may be connected to the input terminal In, the first electrode of the sixth transistor T6 may be connected to the second intermediate node N2, and the second electrode of the sixth transistor T6 may be connected to the control node PD.

The gate of the seventh transistor T7 may be connected to the second clock terminal CKN, the first electrode of the seventh transistor T7 may be connected to the third intermediate node N3, and the second electrode of the seventh transistor T7 may be connected to the control node PD.

As shown in Figs. 5 to 7 and Figs. 35 to 43, the input circuit 01 is the shift register part of the shift register unit, which is composed of mixed P-type and N-type transistors. Cooperating with the clock signal, it realizes the shift latching of the high-level scan signal at the input terminal In and latches it at the control node PD. The storage capacitor C1 is used to ensure the stability of the latched signal. The shift register part provided in the present disclosure has a simpler structure than a conventional latch structure.

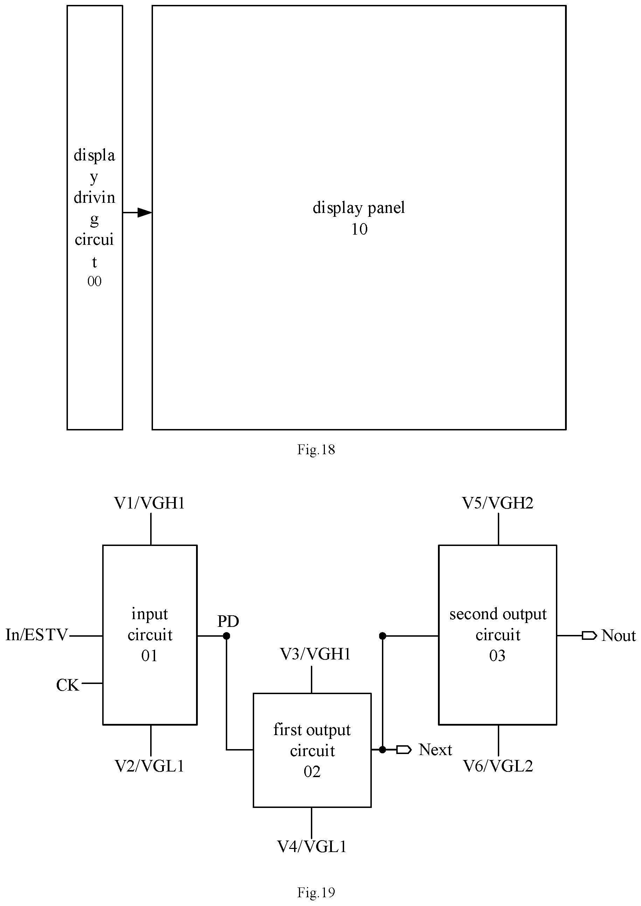

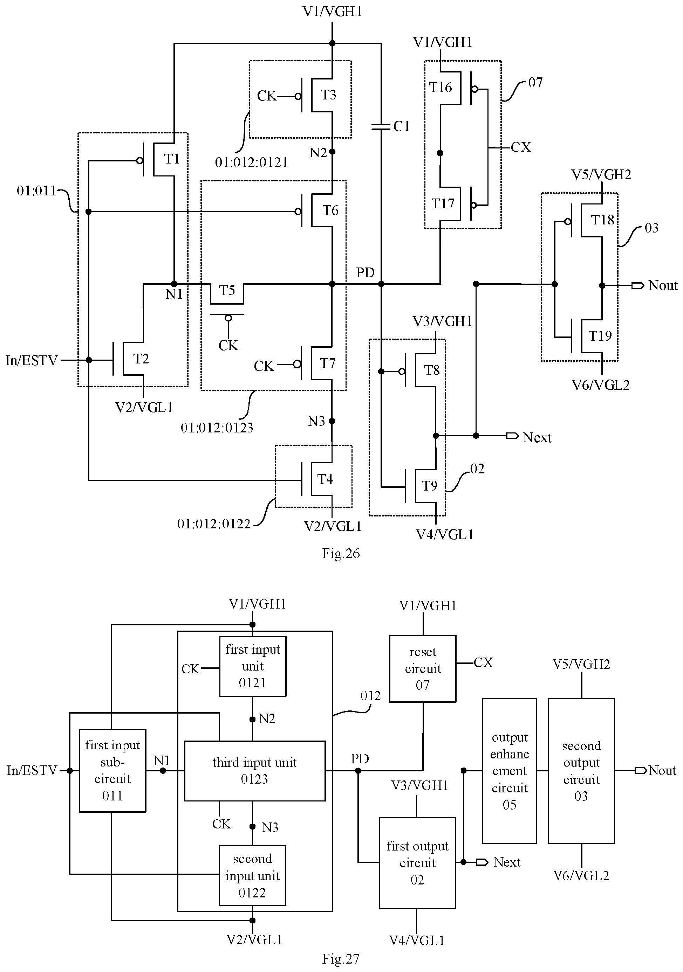

Optionally, as shown in Figs. 19 to 28, the first clock terminal CK is reused as the second clock terminal CKN, and the first clock terminal CK and the second clock terminal CKN are input with the same clock signal.

In more detail, the above setting method is equivalent to configuring the third input unit 0123 in the second input sub-circuit 012 to be connected to the first clock terminal CK, the input terminal In, the first intermediate node N1, the second intermediate node N2, the third intermediate node N3 and the control node PD, respectively. The third input unit 0123 may be configured to control on or off between the first intermediate node N1 and the control node PD in response to the first clock signal, control on or off between the second intermediate node N2 and the control node PD in response to the input signal, and control on or off between the third intermediate node N3 and the control node PD in response to the first clock signal.

For example, the third input unit 0123 may control the first intermediate node N1 to be in a conduction state with the control node PD when the potential of the first clock signal is the first potential, so that the first power supply signal or the second power supply signal transmitted to the first intermediate node N1 can be further transmitted to the control node PD; and may control the first intermediate node N1 to be in a dis-conduction state with the control node PD when the potential of the first clock signal is the second potential. The third input unit 0123 may control the second intermediate node N2 to be in a conduction state with the control node PD when the potential of the input signal is the first potential, so that the first power supply signal transmitted to the second intermediate node N2 can be further transmitted to the control node PD; and may control the second intermediate node N2 to be in a dis-conduction state with the control node PD when the potential of the input signal is the second potential. The third input unit 0123 may control the third intermediate node N3 to be in a conduction state with the control node PD when the potential of the first clock signal is the first potential, so that the second power supply signal transmitted to the third intermediate node N3 can be further transmitted to the control node PD; and may control the third intermediate node N3 to be in a dis-conduction state with the control node PD when the potential of the first clock signal is the second potential.

In this way, with the cooperation of the first input unit 0121, the second input unit 0122 and the third input unit 0123, the first power supply terminal V1 and the second power supply terminal V2 can be in a conduction state with the control node PD in different time periods, respectively, thereby outputting the first power supply signal with a high potential and the second power supply signal with a low potential to the control node PD in different time periods to control the potential of the control node PD to be a high potential or a low potential.

The above setting method is conducive to reducing the number of clock signals to which the shift register unit needs to be connected. When the shift register unit is applied to a display product, it is conducive to reducing the number of clock signal lines that need to be arranged in the display product, simplifying the structure of the display product and narrowing the bezel width of the display product.

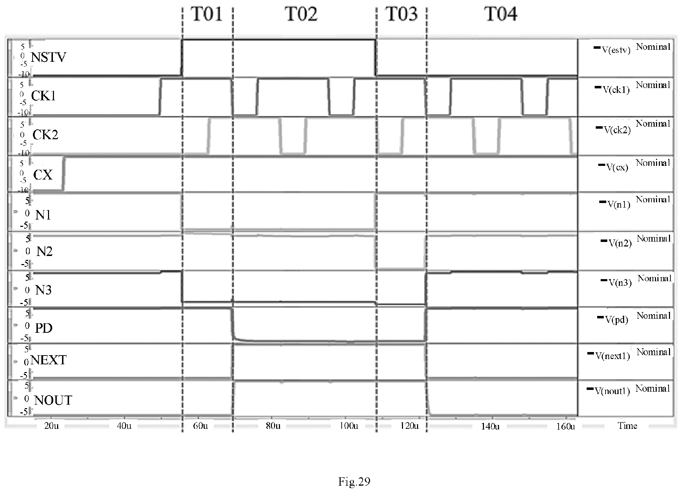

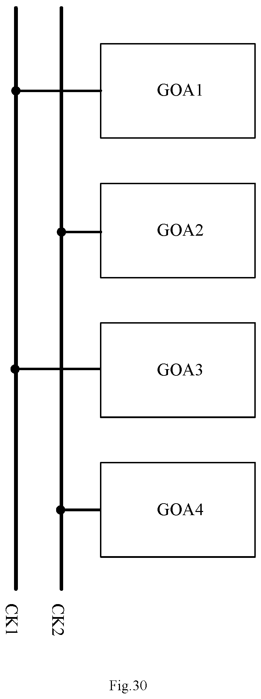

Exemplarily, as shown in Figs. 29 and 30, in the case where the first clock terminal CK is reused as the second clock terminal CKN, when the shift register unit is applied to a display product, two clock signal lines may be arranged in the display product, i.e., a first clock signal line CK1 and a second clock signal line CK2. Meanwhile, the first clock terminal CK coupled to the odd-numbered shift register units (e.g., GOAl, GOA3) in the cascaded shift register units may be coupled to the first clock signal line CK1, and the first clock terminal CK coupled to the even-numbered shift register units (e.g., GOA2, GOA4) in the cascaded shift register units may be coupled to the second clock signal line CK2.

It should be noted that the duty cycles of the first clock signal provided by the first clock signal line CK1 and the second clock signal provided by the second clock signal line CK2 are not limited.

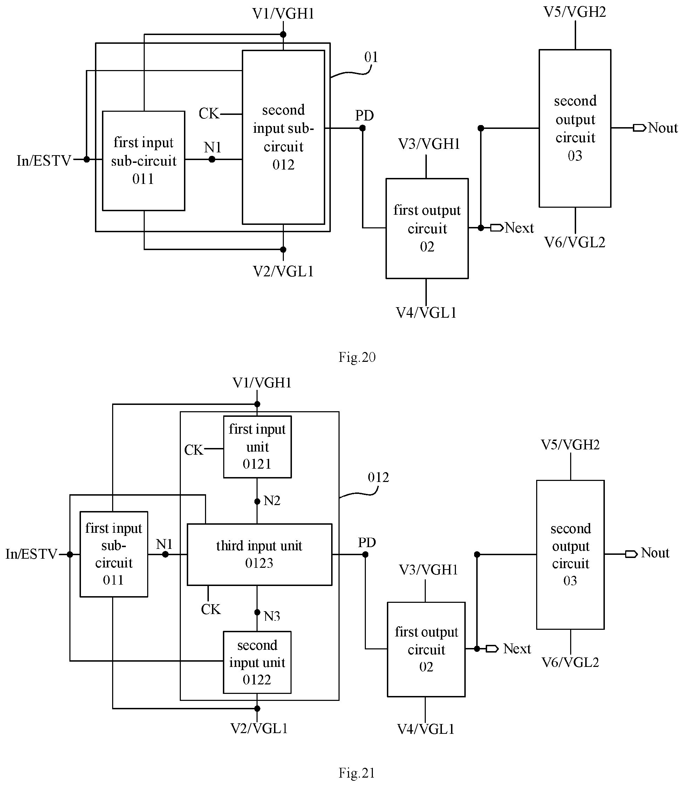

Optionally, as shown in Figs. 21 to 28, the first input unit 0121 may include a third transistor T3, the second input unit 0122 may include a fourth transistor T4, and the third input unit 0123 may include a fifth transistor T5, a sixth transistor T6 and a seventh transistor T7. In addition, the third transistor T3, the fifth transistor T5, the sixth transistor T6 and the seventh transistor T7 may be first-type transistors (e.g., P-type transistors), and the fourth transistor T4 may be a second-type transistor (e.g., N-type transistor).

The gate of the third transistor T3 may be connected to the first clock terminal CK, the first electrode of the third transistor T3 may be connected to the first power supply terminal V1, and the second electrode of the third transistor T3 may be connected to the second intermediate node N2.

The gate of the fourth transistor T4 may be connected to the input terminal In, the first electrode of the fourth transistor T4 may be connected to the second power supply terminal V2, and the second electrode of the fourth transistor T4 may be connected to the third intermediate node N3.

The gate of the fifth transistor T5 may be connected to the first clock terminal CK, the first electrode of the fifth transistor T5 may be connected to the first intermediate node N1, and the second electrode of the fifth transistor T5 may be connected to the control node PD.

The gate of the sixth transistor T6 may be connected to the input terminal In, the first electrode of the sixth transistor T6 may be connected to the second intermediate node N2, and the second electrode of the sixth transistor T6 may be connected to the control node PD.

The gate of the seventh transistor T7 may be connected to the first clock terminal CK, the first electrode of the seventh transistor T7 may be connected to the third intermediate node N3, and the second electrode of the seventh transistor T7 may be connected to the control node PD.

It should be noted that the gate of the seventh transistor T7 may be connected to the first clock terminal CK and is configured to control the turn-on or turn-off of the seventh transistor T7 in response to the first clock signal provided by the first clock terminal CK.

As shown in Figs. 21 to 28, the input circuit 01 is the shift register part of the shift register unit, which is composed of mixed P-type and N-type transistors. Cooperating with the clock signal, it realizes the shift latching of the high-level scan signal at the input terminal In and latches it at the control node PD. The storage capacitor C1 is used to ensure the stability of the latched signal. The shift register provided in the present disclosure has a simpler structure than a conventional latch structure.

It should be noted that the circuit structure shown in Figs. 21 to 28 needs to satisfy the following condition: V_CK < V_VGL1 + Vth@T5&T7, where V_VGL1 refers to the low potential of the power supply signal provided by VGL1, V_CK refers to the potential of the clock signal, and Vth@T5&T7 refers to the minimum value of the threshold voltages of the fifth transistor T5 and the seventh transistor T7. This ensures that VGL1 can be fully written to the control node PD through the fifth transistor T5 and the seventh transistor T7 without charging loss caused by the threshold voltage Vth.

Optionally, with continued reference to Figs. 5 to 7, it can be seen that the first output circuit 02 may include an eighth transistor T8 and a ninth transistor T9. In addition, the eighth transistor T8 may be a first-type transistor (e.g., P-type transistor), and the ninth transistor T9 may be a second-type transistor (e.g., N-type transistor).

The gate of the eighth transistor T8 may be connected to the control node PD, the first electrode of the eighth transistor T8 may be connected to the third power supply terminal V3, and the second electrode of the eighth transistor T8 may be connected to the shift output terminal NEXT.

The gate of the ninth transistor T9 may be connected to the control node PD, the first electrode of the ninth transistor T9 may be connected to the fourth power supply terminal V4, and the second electrode of the ninth transistor T9 may be connected to the shift output terminal NEXT.

Optionally, with continued reference to Figs. 5 and 7, it can be seen that in some embodiments, the second output circuit 03 may include a tenth transistor T10 and an eleventh transistor T11. In addition, the tenth transistor T10 may be a first-type transistor (e.g., P-type transistor), and the eleventh transistor T11 may be a second-type transistor (e.g., N-type transistor).

The gate of the tenth transistor T10 may be connected to the control node PD, the first electrode of the tenth transistor T10 may be connected to the fifth power supply terminal V5, and the second electrode of the tenth transistor T10 may be connected to the driving output terminal Nout.

The gate of the eleventh transistor T11 may be connected to the control node PD, the first electrode of the eleventh transistor T11 may be connected to the sixth power supply terminal V6, and the second electrode of the eleventh transistor T11 may be connected to the driving output terminal Nout.

Optionally, referring to Fig. 6, it can be seen that in some other embodiments, the second output circuit 03 may further include a twelfth transistor T12 connected in series between the fifth power supply terminal V5 and the tenth transistor T10, and a thirteenth transistor T13 connected in series between the sixth power supply terminal V6 and the eleventh transistor T11. In addition, the twelfth transistor T12 and the tenth transistor T10 may be transistors of the same type (e.g., first-type transistor or P-type transistor), and the thirteenth transistor T13 and the eleventh transistor T11 may be transistors of the same type (e.g., second-type transistor or N-type transistor).

The gate of the twelfth transistor T12 may be connected to the control node PD, the first electrode of the twelfth transistor T12 may be connected to the fifth power supply terminal V5, and the second electrode of the twelfth transistor T12 may be connected to the first electrode of the tenth transistor T10.

The gate of the thirteenth transistor T13 may be connected to the control node PD, the first electrode of the thirteenth transistor T13 may be connected to the sixth power supply terminal V6, and the second electrode of the thirteenth transistor T13 may be connected to the first electrode of the eleventh transistor T11.

That is, in some embodiments, as shown in Figs. 5 and 7, the second output circuit 03 may include one P-type transistor T10 and one N-type transistor T11 of different types. in some other embodiments, as shown in Fig. 6, the second output circuit 03 may include two P-type transistors T10&T12 and two N-type transistors T11&T13 of different types, with the two P-type transistors T10&T12 being connected in series and the two N-type transistors T11&T13 being connected in series. The structure shown in Fig. 6 may also be referred to as a dual-TFT series architecture.

It can be understood that the dual-TFT series architecture adopted in the structure shown in Fig. 6 can effectively reduce the current-leakage problem of the transistors in the second output circuit 03 during the turn-on process and ensure the effective output of driving signals with high/low potentials. The current leakage problem is mainly caused by the surge of the driving signals output through the driving output terminal Nout due to the rising edge (transition from a low potential to a high potential) and falling edge (transition from high potential to low potential) of the driving signal output through the driving output terminal Nout.

Optionally, for the dual-TFT series architecture shown in Fig. 6, the tenth transistor T10 and the twelfth transistor T12 connected in series may have different channel width-to-length ratios (W/L); and/or the eleventh transistor T11 and the thirteenth transistor T13 connected in series may have different channel width-to-length ratios (W/L).

That is, in the layout design, the channel width-to-length ratios (W/L) of the two series-connected P-type transistors T10&T12 may be designed differently; and/or the channel width-to-length ratios (W/L) of the two series-connected N-type transistors T11&T13 may also be designed differently. This can fully save the layout space of the circuit board, thereby being more conducive to the narrow bezel design of the display device.

For example, the channel width-to-length ratio (W/L) of the tenth transistor T10 may be greater than that of the twelfth transistor T12. That is, among the two series-connected P-type transistors T10&T12, the transistor directly connected to the fifth power supply terminal V5 (i.e., the twelfth transistor T12) may be designed with a relatively small channel width-to-length ratio (W/L), and the transistor directly connected to the driving output terminal Nout (i.e., the tenth transistor T10) may be designed with a relatively large channel width-to-length ratio (W/L). In this way, the output driving capability of the tenth transistor T10 can be ensured, that is, the reliable output of the fifth power supply signal to the driving output terminal Nout through the tenth transistor T10 can be ensured.

Similarly, the channel width-to-length ratio (W/L) of the eleventh transistor T11 may be greater than that of the thirteenth transistor T13. That is, among the two series-connected N-type transistors T11&T13, the transistor directly connected to the sixth power supply terminal V6 (i.e., the thirteenth transistor T13) may be designed with a relatively small channel width-to-length ratio (W/L), and the transistor directly connected to the driving output terminal Nout (i.e., the eleventh transistor T11) may be designed with a relatively large channel width-to-length ratio (W/L). In this way, the output driving capability of the eleventh transistor T11 can be ensured, that is, the reliable output of the sixth power supply signal to the driving output terminal Nout through the eleventh transistor T11 can be ensured.

It can be understood that the above dual-TFT series architecture is designed for the second output circuit 03 that outputs driving signals to pixels, and the first output circuit 02 used for cascade driving may also be designed in the same manner.

Optionally, with continued reference to Fig. 7, it can be seen that the driving enhancement circuit 04 may include one or a plurality of inverters F connected in series. That is, as described above, the at least one enhancement process may be at least one inversion process. Each inverter F may include a fourteenth transistor T14 and a fifteenth transistor T15 connected in series between the first power supply terminal V1 and the second power supply terminal V2. In addition, the fourteenth transistor T14 may be a first-type transistor (e.g., P-type transistor), and the fifteenth transistor T15 may be a second-type transistor (e.g., N-type transistor).

For example, when the driving enhancement circuit 04 performs an even number of inversion processes (e.g., 2 times), as shown in Fig. 7, the driving enhancement circuit 04 may include two inverters F connected in series. One inverter F may also be referred to as a set of buffer transistors. Correspondingly, the structure shown in Fig. 7 may also be understood as adding two sets of buffer transistors between the control node PD and the second output circuit 03.

For distinction purpose, in Fig. 7, among the two inverters F, the inverter F directly connected to the control node PD is marked as F-1, and the fourteenth transistor T14 and the fifteenth transistor T15 included in the inverter F-1 are marked as T14-1 and T15-1, respectively; the inverter F directly connected to the second output circuit 03 is marked as F-2, and the fourteenth transistor T14 and the fifteenth transistor T15 included in the inverter F-2 are marked as T14-2 and T15-2, respectively.

The gate of the fourteenth transistor T14-1 and the gate of the fifteenth transistor T15-1 may both be connected to the control node PD, the first electrode of the fourteenth transistor T14-1 may be connected to the first power supply terminal V1, the first electrode of the fifteenth transistor T15-1 may be connected to the second power supply terminal V2, the second electrode of the fourteenth transistor T14-1 and the second electrode of the fifteenth transistor T15-1 may both be connected to the gate of the fourteenth transistor T14-2 and the gate of the fifteenth transistor T15-2, the first electrode of the fourteenth transistor T14-2 may be connected to the first power supply terminal V1, the first electrode of the fifteenth transistor T15-2 may be connected to the second power supply terminal V2, and the second electrode of the fourteenth transistor T14-2 and the second electrode of the fifteenth transistor T15-2 may both be connected to the second output circuit 03. For example, for the structures shown in Figs. 5 and 7, the second electrode of the fourteenth transistor T14-2 and the second electrode of the fifteenth transistor T15-2 may both be connected to the gate of the tenth transistor T10 and the gate of the eleventh transistor T11 included in the second output circuit 03. For the structure shown in Fig. 6, the second electrode of the fourteenth transistor T14-2 and the second electrode of the fifteenth transistor T15-2 may both be connected to the gate of the tenth transistor T10, the gate of the eleventh transistor T11, the gate of the twelfth transistor T12 and the gate of the thirteenth transistor T13 included in the second output circuit 03.

Optionally, as shown in Figs. 19 to 44, the second output circuit 03 is connected to the shift output terminal NEXT, so as to be connected to the control node PD through the first output circuit 02. The second output circuit 03 is configured to control on or off between the fifth power supply terminal V5 and the driving output terminal Nout and control on or off between the sixth power supply terminal V6 and the driving output terminal Nout in response to the potential of the shift output terminal NEXT.

For example, under the control of the potential of the shift output terminal NEXT, the second output circuit 03 can make the fifth power supply terminal V5 and the sixth power supply terminal V6 conduct with the driving output terminal Nout in different time periods, respectively. On this basis, it can also be determined that the second output circuit 03 may also include both N-type transistors and P-type transistors.

For example, the second output circuit 03 includes an eighteenth transistor T18 and a nineteenth transistor T19; the gate of the eighteenth transistor T18 is connected to the shift output terminal NEXT, the first electrode of the eighteenth transistor T18 is connected to the fifth power supply terminal V5, and the second electrode of the eighteenth transistor T18 is connected to the driving output terminal Nout; the gate of the nineteenth transistor T19 is connected to the shift output terminal NEXT, the first electrode of the nineteenth transistor T19 is connected to the sixth power supply terminal V6, and the second electrode of the nineteenth transistor T19 is connected to the driving output terminal Nout.

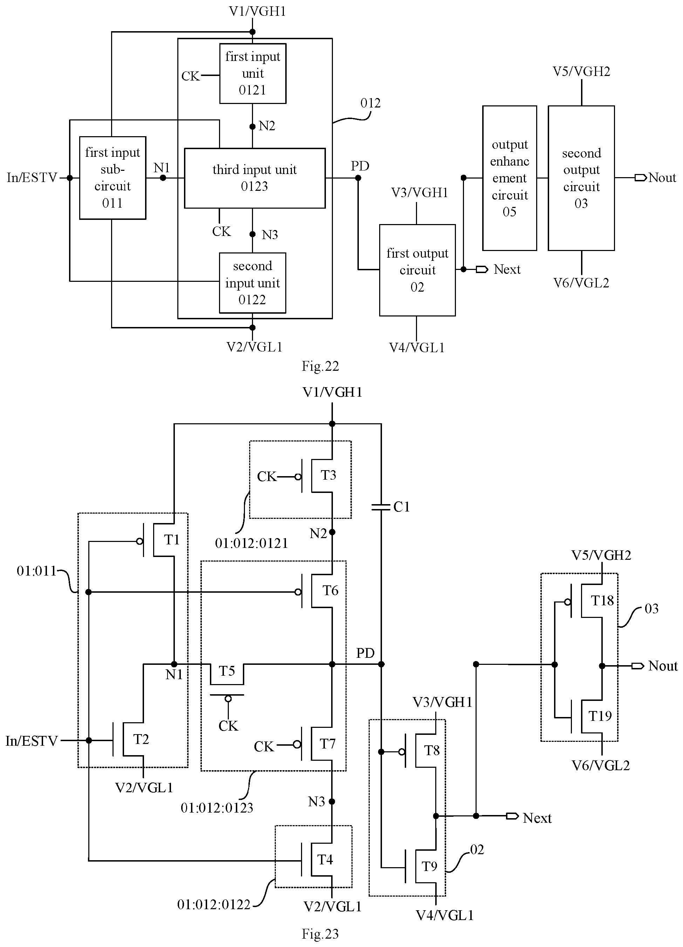

For example, as shown in Figs. 22, 24, 27, 28, 31, 37, 39, 42 and 43, the shift register unit further includes an output enhancement circuit 05 connected between the shift output terminal NEXT and the second output circuit 03 and configured to transmit the potential of the shift output terminal NEXT to the second output circuit 03 after performing at least one enhancement process on the potential of the shift output terminal NEXT. It should be noted that there is a node PD2 between the output enhancement circuit 05 and the second output circuit 03.

For example, the output enhancement circuit 05 includes one or at least two inverters connected in series; each inverter includes a twentieth transistor T20 and a twenty-first transistor T21 connected in series between the first power supply terminal V1 and the second power supply terminal V2; in addition, the twentieth transistor T20 is a first-type transistor, and the twenty-first transistor T21 is a second-type transistor.

Exemplarily, the first output circuit 02, the second output circuit 03 and the output enhancement circuit 05 together form an output part, which adopts a hybrid CMOS circuit architecture. This can effectively reduce the problem of excessive leakage during the turn-on process of transistors and ensure the effective output of high and low levels.

Optionally, referring to Figs. 5 to 7, 19 to 28, 31 and 34 to 43, it can also be seen that the shift register unit may further include a storage capacitor C1 connected between the first power supply terminal V1 and the control node PD. The storage capacitor C1 may be used to maintain the potential of the control node PD and ensure good stability of the potential of the control node PD.

Optionally, in combination with Figs. 1 to 7, 19 to 28, 31 and 34 to 43, it can also be seen that in the embodiments of the present disclosure, the third power supply terminal V3 may be shared with the first power supply terminal V1, and/or the fourth power supply terminal V4 may be shared with the second power supply terminal V2. In this way, the number of signal terminals that need to be set can be simplified, which facilitates wiring and saves costs.

For example, both the first power supply terminal V1 and the third power supply terminal V3 may be the same pull-up power supply terminal VGH1, and both the fourth power supply terminal V4 and the second power supply terminal V2 may be the same pull-down power supply terminal VGL1.

Certainly, in some other embodiments, similar to the third power supply terminal V3, the fifth power supply terminal V5 and the first power supply terminal V1 may also be commonly used, such as the same pull-up power supply terminal VGH1; and/or similar to the fourth power supply terminal V4, the sixth power supply terminal V6 and the second power supply terminal V2 may also be commonly used, such as the same pull-down power supply terminal VGL1. However, in the embodiments of the present disclosure, the fifth power supply terminal V5 and the first power supply terminal V1 may be different power supply terminals (i.e., not shared), such as different pull-up power supply terminals VGH2 and VGH1, respectively; the sixth power supply terminal V6 and the second power supply terminal V2 may be different power supply terminals, such as different pull-down power supply terminals VGL2 and VGL1, respectively. In this way, the second output circuit 03 can independently transmit the required driving signal to the pixels through the driving output terminal Nout, improving the capability of driving the pixels to emit light and reducing current leakage, thereby ensuring reliable driving of the pixels to emit light, reducing the load of the fifth power supply terminal V5 and the sixth power supply terminal V6, and also making the output of the first output circuit 02 through the shift output terminal NEXT and the output of the second output circuit 03 through the driving output terminal Nout independent of each other.

That is, in the embodiments of the present disclosure, dual VGH (i.e., VGH1&VGH2) and dual VGL (i.e., VGL1&VGL2) may be used to supply power to the shift register unit; or, in some other embodiments, single VGH (i.e., VGH1) and single VGL (i.e., VGL1) may also be used to supply power to the shift register unit.

Optionally, in the embodiments of the present disclosure, the first to fourth power supply terminals V1 to V4 and the sixth power supply terminal V6 may all be DC power supply terminals, and the fifth power supply terminal V5 may be a DC power supply terminal or an AC power supply terminal.

That is, in some embodiments, the first to sixth power supply terminals V1 to V6 (e.g., VGH1&VGH2 and VGL1&VGL2) may all be DC power supply terminals that continuously provide power supply signals with a high potential or a low potential.

In some other embodiments, among the first to sixth power supply terminals V1 to V6, the fifth power supply terminal V5 (e.g., VGH2) may be an AC power supply terminal configured to provide a power supply signal with an adjustable high potential or low potential, and the other power supply terminals except the fifth power supply terminal V5 (e.g., VGH1 and VGL1&VGL2) may all be DC power supply terminals configured to continuously provide power supply signals with a high potential or a low potential.

Optionally, as described above, on the basis of setting the fifth power supply terminal V5 as an AC power supply terminal, the potential of the fifth power supply signal provided by the fifth power supply terminal V5 can be flexibly adjusted according to the refresh frequency requirements of different areas in the display panel to adapt to different refresh frequencies required by different areas.

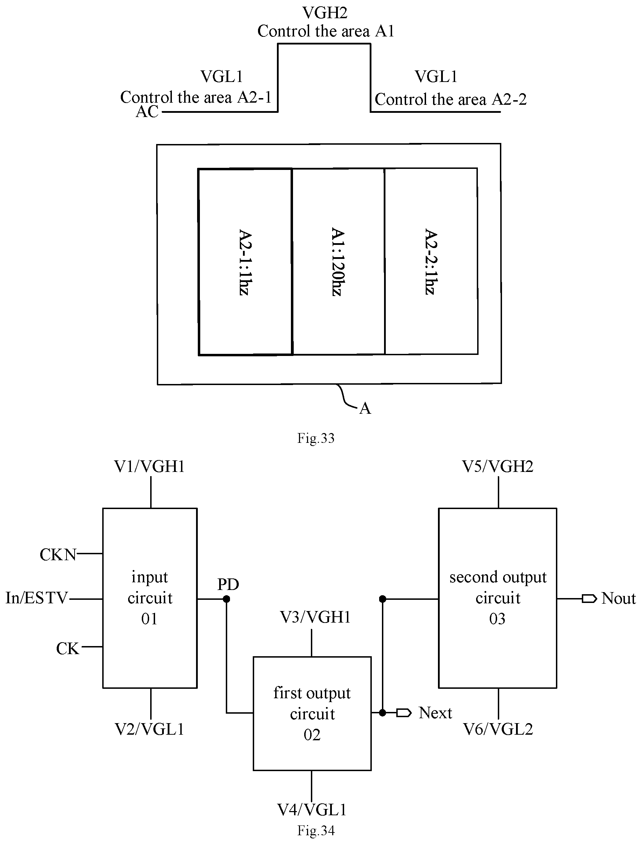

Optionally, as described above, the driving output terminal Nout may be used to connect with pixels in the display area of the display panel to transmit driving signals to the pixels for driving the pixels to emit light. In addition, referring to Figs. 8 and 33, it can be seen that the display area A may include a first display area A1 and a second display area A2. It can be understood that the display area A may be divided into at least one first display area A1 and at least one second display area A2. For example, Figs. 8 and 33 schematically show one first display area A1 and two second display areas A2-1 and A2-2.

The refresh frequency of the first display area A1 may be higher than that of the second display area A2. That is, the first display area A1 may be a high-frequency refresh area, and the second display area A2 (e.g., A2-1 and A2-2) may be a low-frequency refresh area. For example, the refresh frequency of the first display area A1 may be 120 Hz, and the refresh frequency of the second display area A2 may be 1 Hz.

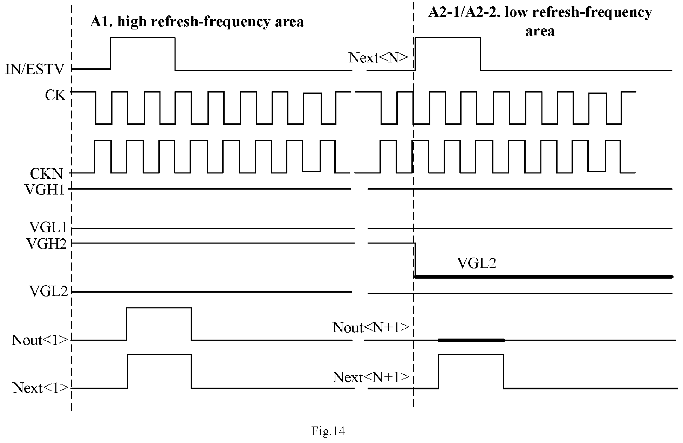

In addition, when driving the pixels in the first display area A1 to emit light, the potential of the fifth power supply signal provided by the fifth power supply terminal V5 (i.e., VGH2) may be higher than the potential of the fifth power supply signal provided by the fifth power supply terminal V5 when driving the pixels in the second display area A2 to emit light. That is, as shown in Figs. 8 and 14, when driving the pixels in the high-frequency refresh area to emit light, the potential of the power supply signal provided by the fifth power supply terminal V5 may be set to a high potential, so that a driving signal with a high potential is reliably output to the pixels in the high-frequency refresh area through the driving output terminal Nout; when driving the pixels in the low-frequency refresh area to emit light, the potential of the power supply signal provided by the fifth power supply terminal V5 may be set to a low potential (e.g., VGL1, VGL2), so that a driving signal with a low potential is reliably output to the pixels in the low-frequency refresh area through the driving output terminal Nout. In this way, the requirements of high-frequency refresh and low-frequency refresh can be met simultaneously.

Optionally, in some embodiments, the low potential of the power supply signal provided by VGH2 may also be equal to the low potential of the sixth power supply signal provided by the sixth power supply terminal V6 (i.e., VGL2). That is, when driving the pixels in the low-frequency refresh area to emit light, the second output circuit 03 may always output driving signals with low potentials to the pixels in the low-frequency refresh area through the driving output terminal Nout.

It can be understood that, in combination with Fig. 6, taking the fifth power supply terminal V5 as VGH2 as an example, in the scenario where the potential of the power supply signal provided by VGH2 is a low potential (i.e., the second output circuit 03 controls the fifth power supply terminal V5 to transmit a fifth power supply signal with a low potential to the driving output terminal Nout), the P-type tenth transistor T10 and the P-type twelfth transistor T12 may be regarded as pull-down transistors at this time; in the scenario where the potential of the power supply signal provided by VGH2 is a high potential (i.e., the second output circuit 03 controls the fifth power supply terminal V5 to transmit a fifth power supply signal with a high potential to the driving output terminal Nout), the P-type tenth transistor T10 and the P-type twelfth transistor T12 may be regarded as pull-up transistors at this time.

On the basis of this embodiment, when driving the pixels in the second display area A2 to emit light, the potential of the fifth power supply signal provided by the fifth power supply terminal V5 may be higher than the potential of the second power supply signal provided by the second power supply terminal V2. That is, when driving the pixels in the low-frequency refresh area to emit light, the low potential of the second power supply signal provided by the second power supply terminal V2 may be lower than the low potential of the fifth power supply signal provided by the fifth power supply terminal V5. For example, on the basis that the fifth power supply terminal V5 is VGH2 and the second power supply terminal is VGL1, it can be considered that the low potential of the power supply signal provided by VGL1 is lower than that of the power supply signal provided by VGH2. Certainly, on the basis that the low potential of the power supply signal provided by VGH2 is equal to that of the power supply signal provided by VGL2, it can also be considered that the low potential of the power supply signal provided by VGL1 is lower than that of the power supply signal provided by VGL2.

It can be understood that by setting the low potential of the second power supply signal provided by the second power supply terminal V2 to be lower than the low potential of the fifth power supply signal provided by the fifth power supply terminal V5 when the fifth power supply signal provided by the fifth power supply terminal V5 is at a low potential, the input circuit 01 can transmit a power supply signal with a sufficiently low potential to the control node PD to pull down the potential of the control node PD as fully as possible, thereby overcoming the problem that the tenth transistor T10 and the twelfth transistor T12 are not fully turned on in response to the low potential of the control node PD when the fifth power supply signal provided by the fifth power supply terminal V5 is at a low potential (i.e., the P-type tenth transistor T10 and the P-type twelfth transistor T12 are used as pull-down transistors).

For example, when the P-type tenth transistor T10 and the twelfth transistor T12 are used as pull-down transistors, taking the case that the first power supply terminal V1 as VGH1, the second power supply terminal V2 as VGL1, the fifth power supply terminal V5 as VGH2, the sixth power supply terminal V6 as VGL2, and the low potential of the power supply signal provided by VGH2 being equal to the low potential of the power supply signal provided by VGL2 as an example, the gate-source voltage difference Vgs of the pull-down transistors can satisfy:
Vgs = V_PD - V_VGL2 < Vth@T10/T12; where V_PD refers to the potential of the control node PD, V_VGL2 refers to the low potential of the power supply signal provided by VGL2 (i.e., the low potential of the power supply signal provided by VGH2), and Vth@T10/T12 refers to the minimum value of the threshold voltage Vth of the tenth transistor T10 and the threshold voltage Vth of the twelfth transistor T12.

Since the low potential of V_PD is the low potential of the power supply signal provided by VGL1, the following can be obtained based on the above formula for Vgs: V_VGL1 < V_VGL2 + Vth@T10/T12; where V_VGL1 refers to the low potential of the power supply signal provided by VGL1.

That is, in the embodiments of the present disclosure, for the embodiment where the low potential V_VGL1 of the power supply signal provided by VGL1 is lower than the low potential V_VGL2 of the power supply signal provided by VGL2, the condition V_VGL1 < V_VGL2 + Vth@T10/T12 needs to be satisfied. For example, in some embodiments, V_VGL1 and V_VGL2 may differ by about 3 volts (V).

Optionally, in some embodiments, the low potential of the first clock signal provided by the first clock terminal CK and/or the low potential of the second clock signal provided by the second clock terminal CKN may also be set to be lower than V_VGL2 + Vth@T10/T12 like V_VGL1, to ensure that the transistors in the input circuit 01 connected to the first clock terminal CK and the second clock terminal CKN can all be fully turned on, thereby ensuring good working reliability of the shift register unit.

It can be understood that when the fifth power supply terminal V5 is set as an AC power supply terminal and the fifth power supply terminal V5 and the third power supply terminal V3 are not commonly used, the shift signal output by the first output circuit 02 through the shift output terminal NEXT will not be affected when the potential of the fifth power supply signal provided by the fifth power supply terminal V5 is adjusted to switch between high and low potentials, that is, the cascade driving will not be affected.

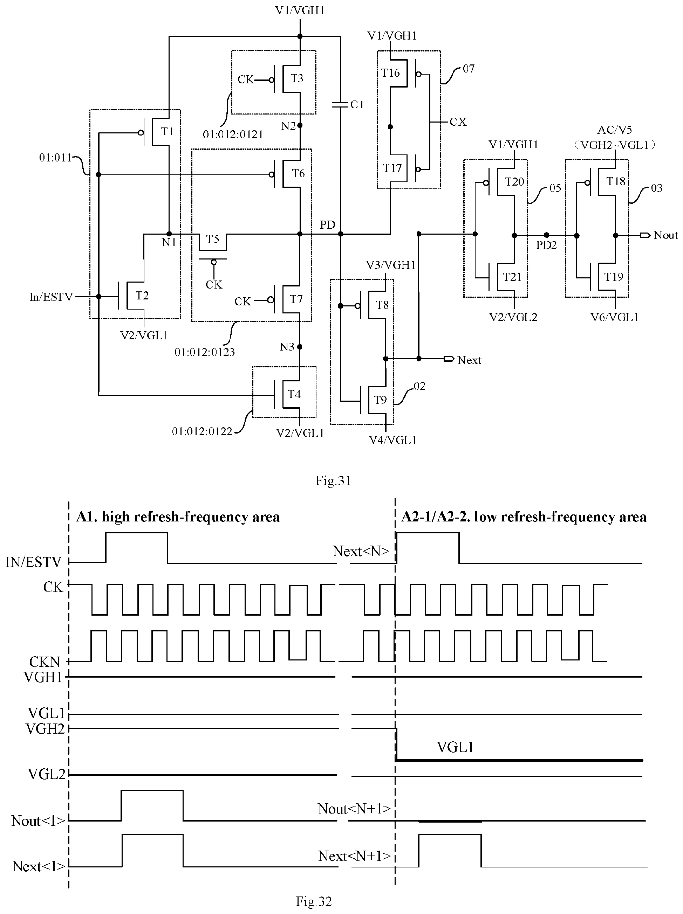

As shown in Figs. 31 to 33, in some embodiments, the fifth power supply terminal V5 is configured as an AC power supply terminal. When driving the pixels in the high-frequency refresh area to emit light, the potential of the power supply signal provided by the fifth power supply terminal V5 may be set to a high potential (e.g., VGH2), so that a driving signal with a high potential is reliably output to the pixels in the high-frequency refresh area through the driving output terminal Nout; when driving the pixels in the low-frequency refresh area to emit light, the potential of the power supply signal provided by the fifth power supply terminal V5 may be set to a low potential (e.g., VGL1), and the potential of the power supply signal provided by the second power supply terminal V2 is set to a low potential (e.g., VGL2) at the same time.

In the shift register unit provided in the above embodiments, the stage-by-stage transmission of the signal at the shift output terminal NEXT is not affected when the fifth power supply terminal V5 switches from VGH2 to VGL1.

It should be noted that the realization of the partial-refresh function needs to be matched with a low level at the control node PD, and to ensure that VGL1 can be written into the driving output terminal Nout from the eighteenth transistor T18 after the fifth power supply terminal V5 switches from VGH2 to VGL1, the following condition must be satisfied: V_VGL2 < V_VGL1 + Vth@T18, where V_VGL1 refers to the low potential of the power supply signal provided by VGL1, V_VGL2 refers to the low potential of the power supply signal provided by VGL2, and Vth@T18 refers to the threshold voltage of the eighteenth transistor T18. This ensures that VGL1 can be fully written into the driving output terminal Nout after the fifth power supply terminal V5 switches from VGH2 to VGL1.

In the shift register unit provided in the above embodiments, by configuring the fifth power supply terminal V5 as an AC power supply terminal, the partial-refresh function can be realized according to actual requirements, enabling different refresh frequencies to be adopted in different areas.

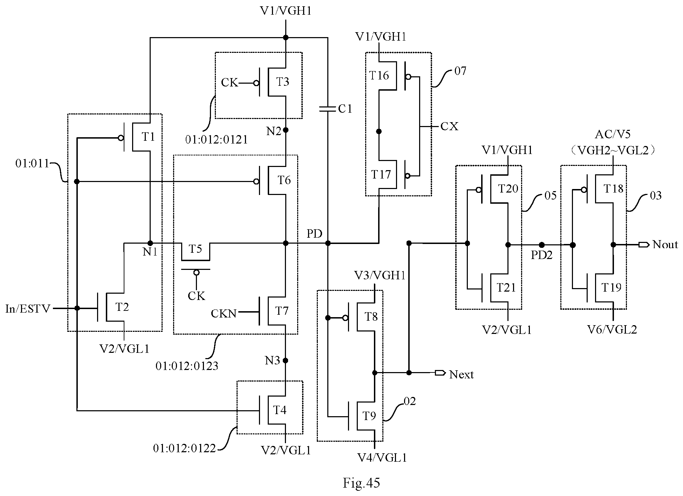

As shown in Figs. 8, 14 and 45, in some embodiments, the fifth power supply terminal V5 is configured as an AC power supply terminal. When driving the pixels in the high-frequency refresh area to emit light, the potential of the power supply signal provided by the fifth power supply terminal V5 may be set to a high potential (e.g., VGH2), so that a driving signal with a high potential is reliably output to the pixels in the high-frequency refresh area through the driving output terminal Nout; when driving the pixels in the low-frequency refresh area to emit light, the potential of the power supply signal provided by the fifth power supply terminal V5 may be set to a low potential (e.g., VGL2), and the potential of the power supply signal provided by the second power supply terminal V2 is set to a low potential (e.g., VGL1) at the same time.

In the shift register unit provided in the above embodiments, the stage-by-stage transmission of the signal at the shift output terminal NEXT is not affected when the fifth power supply terminal V5 switches from VGH2 to VGL2.

It should be noted that the realization of the partial-refresh function needs to be matched with a low level at the control node PD, and to ensure that VGL2 can be written into the driving output terminal Nout from the eighteenth transistor T18 after the fifth power supply terminal V5 switches from VGH2 to VGL2, the following condition must be satisfied: V_VGL1 < V_VGL2 + Vth@T18, where V_VGL1 refers to the low potential of the power supply signal provided by VGL1, V_VGL2 refers to the low potential of the power supply signal provided by VGL2, and Vth@T18 refers to the threshold voltage of the eighteenth transistor T18. This ensures that VGL2 can be fully written into the driving output terminal Nout after the fifth power supply terminal V5 switches from VGH2 to VGL2.

In the shift register unit provided in the above embodiment, by configuring the fifth power supply terminal V5 as an AC power supply terminal, the partial-refresh function can be realized according to actual requirements, enabling different refresh frequencies to be adopted in different areas.

As can be seen from the above description, the shift register units shown in Figs. 5 and 6 each consist of three parts: an input circuit 01 (also referred to as the shift register part), a first output circuit 02 (also referred to as the transmission unit), and a second output circuit 03 (also referred to as the output unit). In addition to the above three parts, the shift register unit shown in Fig. 7 further includes a driving enhancement circuit 04 (also referred to as the enhancement unit). Moreover, it can be seen from Figs. 5 to 7 that:
the shift register part may include 4 P-type transistors and 3 N-type transistors, adopting a hybrid TFT architecture of P-type + N-type. Cooperating with the clock signals provided by the first clock terminal CK and the second clock terminal CKN, it can realize shift latching of the input signal provided by the input terminal In and latch it at the control node PD, with the storage capacitor C1 ensuring the stability of the latching. As a core architecture, the shift register part features a simple structure and a small number of required devices.

The transmission unit may include 1 P-type transistor and 1 N-type transistor, similar to a set of diodes. By utilizing the transmission function of the set of diodes, the signal shift-latched to the control node PD can be further transmitted to the input terminals In of other cascaded shift register units to achieve cascade output.

In one embodiment, as shown in Figs. 5 and 7, the output unit may include 1 P-type transistor and 1 N-type transistor. in some other embodiments, as shown in Fig. 6, the output unit may include 2 series-connected P-type transistors and 2 series-connected N-type transistors. This structure can reduce current leakage and ensure the reliable output of the required driving signal to the pixels.

The enhancement unit may include one inverter or a plurality of series-connected inverters F. Each inverter F may include 1 P-type transistor and 1 N-type transistor, equivalent to a set of buffer transistors.

That is, the shift register unit shown in Fig. 5 includes 6 P-type transistors, 5 N-type transistors and 1 capacitor, belonging to a shift register unit of a 11T1C architecture. The shift register unit shown in Fig. 6 includes 7 P-type transistors, 6 N-type transistors and 1 capacitor, belonging to a shift register unit of a 13T1C architecture. The shift register unit shown in Fig. 7 includes 8 P-type transistors, 7 N-type transistors and 1 capacitor, belonging to a shift register unit of a 15T1C architecture. Certainly, the design is not limited to the above structures. In addition, the structures shown in Figs. 5 to 7 are all driven by two independent sets of clock signals (the clock signals provided by CK and CKN respectively) and two independent sets of power supply signals (the two sets of power supply signals provided by VGH1/VGL1 and VGH2/VGL2 respectively), with the shift output terminal NEXT and the driving output terminal Nout being independent of each other. The required input signal is transmitted to the input terminal In of other cascaded shift register units through the shift output terminal NEXT, and the required driving signal is transmitted to the pixel circuit through the driving output terminal Nout. The shift register unit provided in the embodiments of the present disclosure has a simple structure and rich functions.

In summary, the embodiments of the present application provide a shift register unit. In this shift register unit, the input circuit can transmit power supply signals of different potentials to the control node in different time periods in response to the input signal and the clock signal, and both output circuits can transmit power supply signals of different potentials to their connected output terminals in different time periods in response to the potential of the control node. Therefore, it can be determined that the shift register unit includes both P-type transistors and N-type transistors, and the two output circuits can output signals to their connected output terminals independently of each other. On this basis, by flexibly adjusting the potential of the power supply signal, the driving output terminal connected to the pixels can reliably transmit driving signals of the required potential to the pixels in areas with different refresh frequencies to support the partial-refresh function. The shift register unit has a simple structure and rich functions.

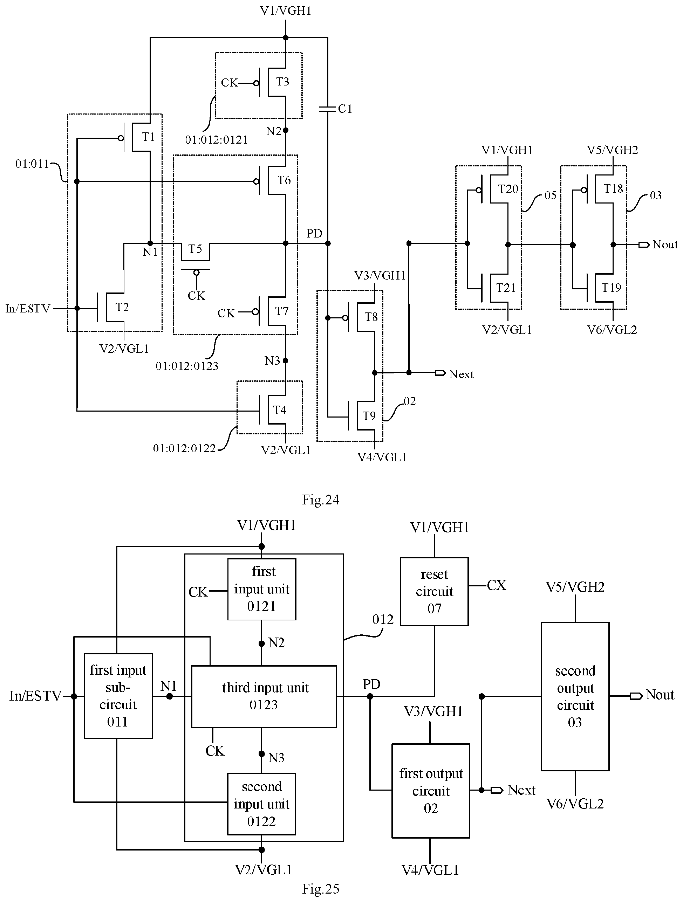

In some embodiments, as shown in Figs. 25 to 28 and 40 to 43, the shift register unit further includes a reset circuit 07, which is connected to a reset signal terminal CX, the first power supply terminal V1 and the control node PD, and is configured to control on or off between the first power supply terminal V1 and the control node PD in response to the reset signal provided by the reset signal terminal CX.

Exemplarily, the reset circuit 07 includes a sixteenth transistor T16 and a seventeenth transistor T17; the gate of the sixteenth transistor T16 is connected to the reset signal terminal CX, the first electrode of the sixteenth transistor T16 is connected to the first power supply terminal V1, and the second electrode of the sixteenth transistor T16 is connected to the first electrode of the seventeenth transistor T17; the gate of the seventeenth transistor T17 is connected to the reset signal terminal CX, and the second electrode of the seventeenth transistor T17 is connected to the control node PD.

Exemplarily, in the reset phase, the reset circuit 07 controls the first power supply terminal V1 to be in a conduction state with the control node PD in response to the reset signal provided by the reset signal terminal CX.

During the power-on process of the shift register unit, the reset signal terminal CX and the first power supply terminal V1 are controlled to be powered on first, so that the reset circuit 07 conducts the electrical connection between the first power supply terminal V1 and the control node PD. This ensures that the control node PD has a high potential during the power-on process of the shift register unit, which can turn off the twentieth transistor T20, the eighteenth transistor T18 and the eighth transistor T8 controlled by the control node PD, avoiding VGH1 from being in a conduction state with VGL1 as well as avoiding VGH2 from being in a conduction state with VGL2 at the moment of startup. Thus, VGH1, VGL1, VGH2 and VGL2 maintain the expected output potential before power-on, preventing abnormal operation of the shift register unit and avoiding large inrush current during power-on. After the power-on of the shift register unit is completed, the reset signal terminal CX controls the disconnection of the electrical connection between the first power supply terminal V1 and the control node PD.

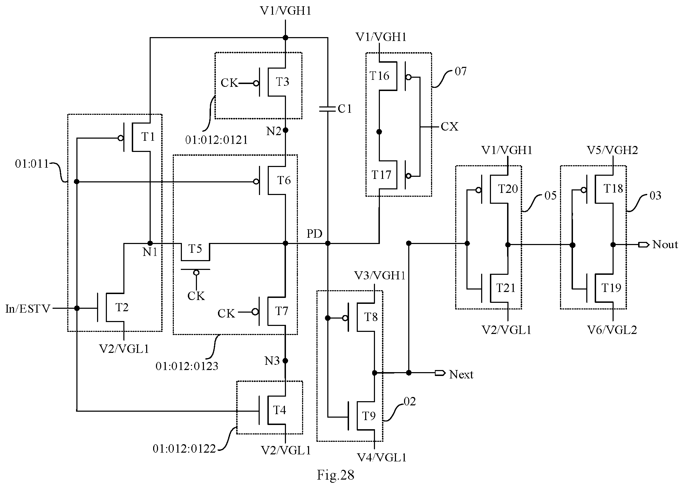

In some embodiments, as shown in Figs. 28 and 29, the shift register unit includes 10 P-type transistors, 5 N-type transistors and 1 capacitor. Taking the connection of the first clock terminal CK to the first clock signal line CK1 as an example, the working process of the shift register with this circuit structure is described in detail below:
a reset phase: a low potential is written to the reset signal terminal CX to ensure the turn-on of the sixteenth transistor T16 and the seventeenth transistor T17, completing the discharge and reset of the control node PD; the control node PD is kept at a high potential before other signals are enabled, preventing output noise caused by abnormal power-on of the shift register unit;
a phase T01: the potential of the input signal provided by the input terminal In (i.e., the enable signal terminal NSTV) may be a high potential, and the potential of the first clock signal provided by the first clock terminal CK may be a high potential. This can turn off both the P-type first transistor T1 and the P-type sixth transistor T6, and turn on both the N-type second transistor T2 and the N-type fourth transistor T4; at this time, a power supply signal with a low potential can be written to the first intermediate node N1 and the third intermediate node N3, while the potential of the second intermediate node N2 and the potential of the control node PD can both remain at the high potential before the phase T01;
a phase T02: the potential of the first clock signal provided by the first clock terminal CK may be a low potential, turning on the seventh transistor T7 and continuously writing a low potential to the control node PD; in this phase, the eighth transistor T8 is turned on to complete the signal output of the shift output terminal NEXT, and the twenty-first transistor T21 and the eighteenth transistor T18 are turned on at the same time to transmit a driving signal with a high potential to the pixel circuit through the driving output terminal Nout;
a phase T03: the potential of the input signal provided by the input terminal In may be a low potential, turning off both the second transistor T2 and the fourth transistor T4, and turning on both the first transistor T1 and the sixth transistor T6 at the same time to pull up the potential of node N1; at this time, the first clock signal turns off the third transistor T3 and the fifth transistor T5, the potential of the control node PD can remain at the low potential before the phase T03, and the potential of the second intermediate node N2 and the potential of the third intermediate node N3 can also both remain at a low potential (e.g., for a duration of one horizontal scanning period (1H)). The shift output terminal NEXT and the driving output terminal Nout continuously output a high potential VGH2 for 1H;
a phase T04: both the first transistor T1 and the sixth transistor T6 are controlled to be turned on, and the potential of the first clock signal provided by the first clock terminal CK may first be a low potential; the first clock signal turns on the third transistor T3 and the fifth transistor T5, and a high level starts to be written to the control node PD, completing a shift rise of the control node PD from a low level to a high level; in this phase, the eighth transistor T8 is turned off and the ninth transistor T9 is turned on to control the shift output terminal NEXT to output VGL1, and the twentieth transistor T20 and the nineteenth transistor T19 are turned on at the same time to complete the output of one scanning signal.

As shown in Fig. 29, in Phase T04, the potential of the first intermediate node N1, the potential of the second intermediate node N2 and the potential of the third intermediate node N3 may all be high potentials, and the potential of the control node PD may be a high potential. On this basis, the potential of the shift signal output through the shift output terminal NEXT and the potential of the driving signal output through the driving output terminal Nout may both be low potentials. Thereafter, Phase T04 can be executed repeatedly. The falling edges of the shift signal and the driving signal output by the shift register unit provided in the embodiments of the present disclosure have no steps, and the output reliability is good.

The shift register provided in the above embodiment can meet the driving requirements of the existing GateN GOA, and can also be used as an EM GOA. The falling edge of the output driving signal has no steps, and the driving capability is stronger than that of a conventional GOA. The shift register adopts a hybrid CMOS circuit architecture to realize the shift output of GateN, and is also compatible with the partial-refresh function to support the driving requirements of the partial-refresh circuit. It has a simpler circuit architecture and realizes corresponding functions with fewer transistors, which is more advantageous for realizing narrow bezels compared with the prior art.

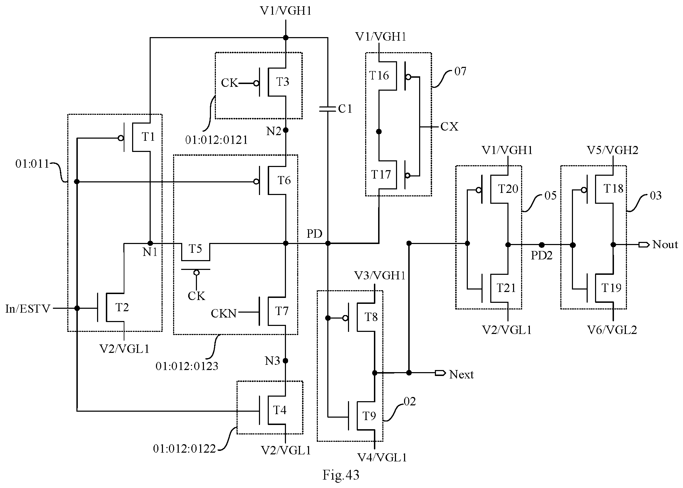

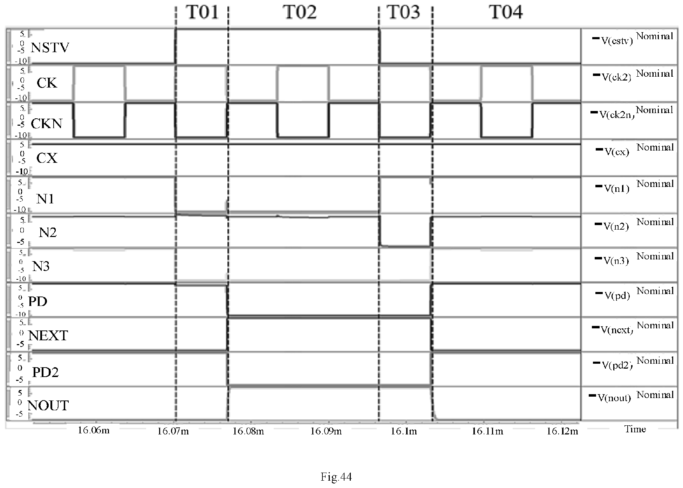

In some embodiments, as shown in Figs. 43 and 44, the shift register unit includes 9 P-type transistors, 6 N-type transistors and 1 capacitor. The working process of the shift register with this circuit structure is described in detail below:
a Reset Phase: a low potential is written to the reset signal terminal CX to ensure the turn-on of the sixteenth transistor T16 and the seventeenth transistor T17, completing the discharge and reset of the control node PD; the control node PD is kept at a high potential before other signals are provided, preventing output noise caused by abnormal power-on of the shift register unit;
a Phase T01: the potential of the input signal provided by the input terminal In (i.e., the enable signal terminal NSTV) may be a high potential, and the potential of the first clock signal provided by the first clock terminal CK may be a high potential; this can turn off the first transistor T1, the sixth transistor T6, the third transistor T3 and the fifth transistor T5, and turn on both the second transistor T2 and the fourth transistor T4; at this time, a power supply signal with a low potential can be written to the first intermediate node N1 and the third intermediate node N3, and the potential of the control node PD can remain at the high potential before Phase T01;
a Phase T02: the potential of the second clock signal provided by the second clock terminal CKN may be a high potential, turning on the seventh transistor T7; the potential of the first clock signal provided by the first clock terminal CK may be a low potential, turning on the fifth transistor T5 and continuously writing a low potential to the control node PD; in this phase, the eighth transistor T8 is turned on to complete the signal output of the shift output terminal NEXT, and the twenty-first transistor T21 and the eighteenth transistor T18 are turned on at the same time to transmit a driving signal with a high potential to the pixel circuit through the driving output terminal Nout;
a Phase T03: the potential of the input signal provided by the input terminal In may be a low potential, turning off both the second transistor T2 and the fourth transistor T4, and turning on both the first transistor T1 and the sixth transistor T6 at the same time to pull up the potential of node N1; at this time, the first clock signal turns off the third transistor T3 and the fifth transistor T5, the potential of the control node PD can remain at the low potential before Phase T03, and the potential of the second intermediate node N2 and the potential of the third intermediate node N3 can also both remain at a low potential (e.g., for a duration of one horizontal scanning period (1H)); the shift output terminal NEXT and the driving output terminal Nout continuously output a high potential VGH2 for 1H;
a Phase T04: both the first transistor T1 and the sixth transistor T6 are controlled to be turned on, and the potential of the first clock signal provided by the first clock terminal CK may first be a low potential; the first clock signal turns on the third transistor T3 and the fifth transistor T5, and a high level starts to be written to the control node PD, completing a shift rise of the control node PD from a low level to a high level; in this phase, the eighth transistor T8 is turned off and the ninth transistor T9 is turned on to control the shift output terminal NEXT to output VGL1, and the twentieth transistor T20 and the nineteenth transistor T19 are turned on at the same time to complete the output of one scanning signal.

As shown in Fig. 44, in this phase T04, the potentials of the first intermediate node N1, the second intermediate node N2 and the third intermediate node N3 can all be high, and the potential of the control node PD can also be high. On this basis, the potential of the shift signal output via the shift output terminal NEXT and the potential of the drive signal output via the drive output terminal Nout can both be low. Thereafter, this phase T04 can be executed repeatedly. The falling edges of the shift signal and the drive signal output by the shift register unit provided in the embodiments of the present disclosure are free of steps, resulting in good output reliability.

The shift register provided in the above embodiments can meet the driving requirements of the existing GateN GOA and can also be used as an EM GOA. The falling edge of the output drive signal is free of steps, and the driving capability is stronger than that of the conventional GOA. The shift register adopts a hybrid CMOS circuit architecture to realize the shift output of GateN, and is also compatible with the partial-refresh function, which can support the circuit driving requirements of the partial-refresh. The circuit architecture is simpler, and the corresponding functions are realized with fewer transistors, which has more advantages for realizing narrow bezel in the related art.

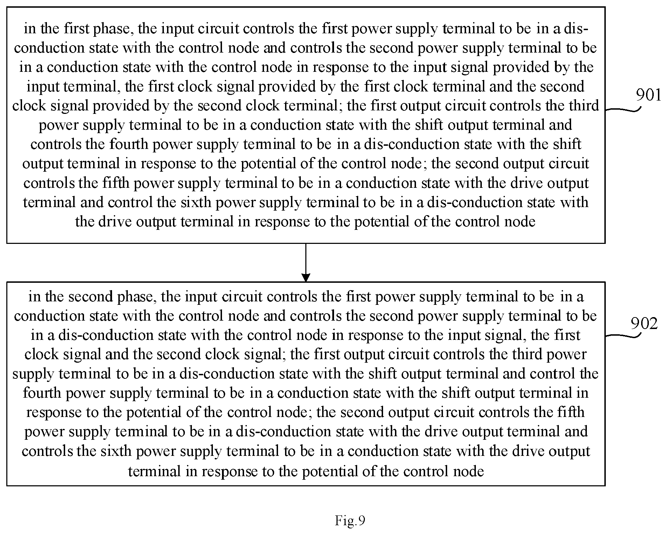

The embodiment of the present application also provides a driving method for a shift register unit, which is used to drive the shift register unit as shown in any one of Figs. 1 to 7. As shown in Fig. 9, the method includes:
step 901: in the first phase, the input circuit controls the first power supply terminal to be in a dis-conduction state with the control node and the second power supply terminal to be in a conduction state with the control node in response to the input signal provided by the input terminal, the first clock signal provided by the first clock terminal and the second clock signal provided by the second clock terminal. The first output circuit controls the third power supply terminal to be in a conduction state with the shift output terminal and controls the fourth power supply terminal to be in a dis-conduction state with the shift output terminal in response to the potential of the control node. The second output circuit controls the fifth power supply terminal to be in a conduction state with the drive output terminal and control the sixth power supply terminal to be in a dis-conduction state with the drive output terminal in response to the potential of the control node.

Step 902: in the second phase, the input circuit controls the first power supply terminal to be in a conduction state with the control node and control the second power supply terminal to be in a dis-conduction state with the control node in response to the input signal, the first clock signal and the second clock signal. The first output circuit controls the third power supply terminal to be in a dis-conduction state with the shift output terminal and control the fourth power supply terminal to be in a conduction state with the shift output terminal in response to the potential of the control node. The second output circuit controls the fifth power supply terminal to be in a dis-conduction state with the drive output terminal and controls the sixth power supply terminal to be in a conduction state with the drive output terminal in response to the potential of the control node.

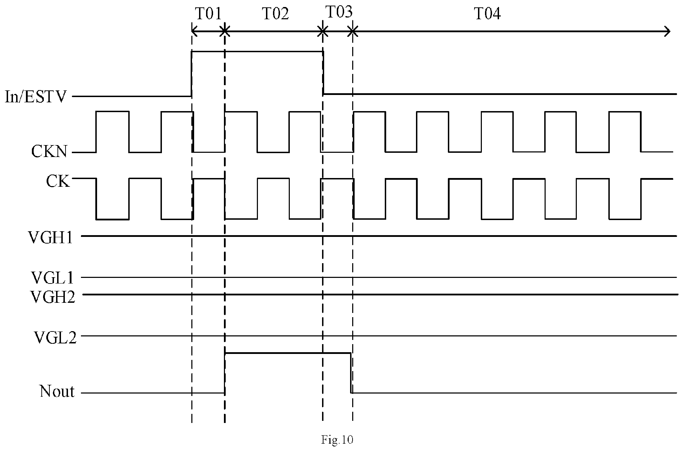

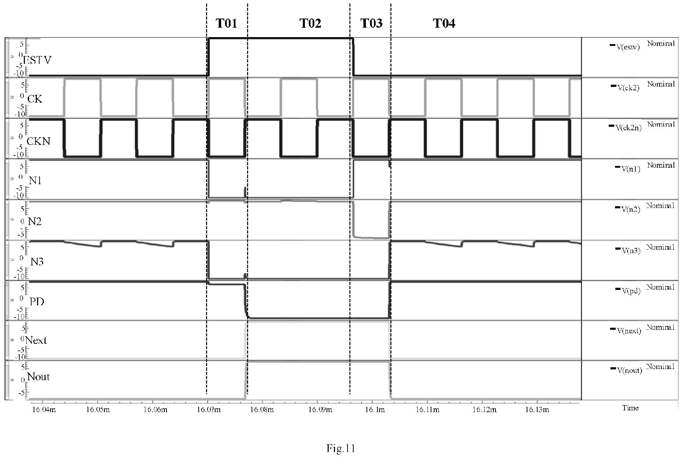

Optionally, taking as an example the structure shown in Fig. 6 with the first potential being low and the second potential being high, Fig. 10 shows an operating timing diagram of a shift register unit, and Fig. 11 correspondingly shows a simulation diagram of the operating timing diagram shown in Fig. 10. The driving principle of the shift register unit is explained below in combination with Figs. 10 and 11.
(1) In phase T01, the potential of the input signal provided by the input terminal In (i.e., the enable signal terminal ESTV) can be high, the potential of the first clock signal provided by the first clock terminal CK can be high, and the potential of the second clock signal provided by the second clock terminal CKN can be low. Correspondingly, the P-type first transistor T1 and the P-type sixth transistor T6 can be controlled to be turned off, the N-type second transistor T2 and the N-type fourth transistor T4 can be controlled to be turned on, and the P-type third transistor T3, the P-type fifth transistor T5 and the N-type seventh transistor T7 can all be controlled to turn off. In this way, the second power supply terminal V2 (i.e., the pull-down power supply terminal VGL1) can be in a conduction state with both the first intermediate node N1 and the third intermediate node N3, the first power supply terminal V1 (i.e., the pull-up power supply terminal VGH1) can be in a dis-conduction state with both the first intermediate node N1 and the second intermediate node N2, and the first intermediate node N1, the second intermediate node N2 and the third intermediate node N3 can all be in a dis-conduction state with the control node PD. Further, the low-potential power supply signal provided by the pull-down power supply terminal VGL1 can be transmitted to the first intermediate node N1 via the turned-on second transistor T2 and to the third intermediate node N3 via the turned-on fourth transistor T4. That is, in this phase T01, a low-potential power supply signal can be written into the first intermediate node N1 and the third intermediate node N3, while the potential of the second intermediate node N2 and the potential of the control node PD can both remain at the high potential before phase T01.

On the basis that the potential of the control node PD is high, the P-type eighth transistor T8, the P-type tenth transistor T10 and the P-type twelfth transistor T12 can be controlled to be turned off, and the N-type ninth transistor T9, the N-type eleventh transistor T11 and the N-type thirteenth transistor T13 can be controlled to be turned on. In this way, the fourth power supply terminal V4 (i.e., the pull-down power supply terminal VGL1) can be conducted to the shift output terminal NEXT, the third power supply terminal V3 (i.e., the pull-up power supply terminal VGH1) can be in a dis-conduction state with the shift output terminal NEXT, the sixth power supply terminal V6 (i.e., the pull-down power supply terminal VGL2) can be in a conduction state with the drive output terminal Nout, and the fifth power supply terminal V5 (i.e., the pull-up power supply terminal VGH2) can be in a dis-conduction state with the drive output terminal Nout. Further, the low-potential power supply signal provided by the pull-down power supply terminal VGL1 can be transmitted to the shift output terminal NEXT via the turned-on ninth transistor T9, and the low-potential power supply signal provided by the pull-down power supply terminal VGL2 can be transmitted to the drive output terminal Nout sequentially via the turned-on thirteenth transistor T13 and eleventh transistor T11. That is, in this phase T01, a low-potential input signal can be transmitted to the input terminal In of other cascaded shift register units via the shift output terminal NEXT, and a low-potential drive signal can be transmitted to the pixel circuit via the drive output terminal Nout.

That is, in combination with Figs. 10 and 11, in this phase T01, the potentials of the first intermediate node N1 and the third intermediate node N3 can both be low, and the potentials of the second intermediate node N2 and the control node PD can both be high. On this basis, the potential of the shift signal output via the shift output terminal NEXT and the potential of the drive signal output via the drive output terminal Nout can both be low.

(2) In phase T02, the potential of the input signal provided by the input terminal In (i.e., the enable signal terminal ESTV) can be high, the potential of the first clock signal provided by the first clock terminal CK can be low, and the potential of the second clock signal provided by the second clock terminal CKN can be high. Correspondingly, the P-type first transistor T1 and the P-type sixth transistor T6 can be controlled to be turned off, the N-type second transistor T2 and the N-type fourth transistor T4 can be controlled to be turned on, and the P-type third transistor T3, the P-type fifth transistor T5 and the N-type seventh transistor T7 can all be controlled to turn on. In this way, the second power supply terminal V2 (i.e., the pull-down power supply terminal VGL1) can be in a conduction state with both the first intermediate node N1 and the third intermediate node N3, the first intermediate node N1 and the third intermediate node N3 can both be in a conduction state with the control node PD, the first power supply terminal V1 (i.e., the pull-up power supply terminal VGH1) can be in a conduction state with the second intermediate node N2, the first power supply terminal V1 can be in a dis-conduction state with the first intermediate node N1, and the second intermediate node N2 can be in a dis-conduction state with the control node PD. Further, the low-potential power supply signal provided by the pull-down power supply terminal VGL1 can be transmitted to the first intermediate node N1 via the turned-on second transistor T2 and to the third intermediate node N3 via the turned-on fourth transistor T4; the high-potential power supply signal provided by the pull-up power supply terminal VGH1 can be transmitted to the second intermediate node N2 via the turned-on third transistor T3; the low-potential power supply signal transmitted to the first intermediate node N1 can be further transmitted to the control node PD via the turned-on fifth transistor T5; and the low-potential power supply signal transmitted to the third intermediate node N3 can be further transmitted to the control node PD via the turned-on seventh transistor T7. That is, in this phase T02, a low-potential power supply signal can continue to be written into the first intermediate node N1 and the third intermediate node N3, the low-potential power supply signal can be further controlled to be written into the control node PD, and a high-potential power supply signal can be written into the second intermediate node N2.

On the basis that the potential of the control node PD is low, the P-type eighth transistor T8, the P-type tenth transistor T10 and the P-type twelfth transistor T12 can be controlled to be turned on, and the N-type ninth transistor T9, the N-type eleventh transistor T11 and the N-type thirteenth transistor T13 can be controlled to be turned off. In this way, the third power supply terminal V3 (i.e., the pull-up power supply terminal VGH1) can be in a conduction state with the shift output terminal NEXT, the fourth power supply terminal V4 (i.e., the pull-down power supply terminal VGL1) can be in a dis-conduction state with the shift output terminal NEXT, the fifth power supply terminal V5 (i.e., the pull-up power supply terminal VGH2) can be in a conduction state with the drive output terminal Nout, and the sixth power supply terminal V6 (i.e., the pull-down power supply terminal VGL2) can be in a dis-conduction state with the drive output terminal Nout. Further, the high-potential power supply signal provided by the pull-up power supply terminal VGH1 can be transmitted to the shift output terminal NEXT via the turned-on eighth transistor T8, and the high-potential power supply signal provided by the pull-up power supply terminal VGH2 can be transmitted to the drive output terminal Nout sequentially via the turned-on twelfth transistor T12 and tenth transistor T10. That is, in this phase T02, a high-potential input signal can be transmitted to the input terminal In of other cascaded shift register units via the shift output terminal NEXT, and a high-potential drive signal can be transmitted to the pixel circuit via the drive output terminal Nout.

That is, in combination with Figs. 10 and 11, in this phase T02, the potentials of the first intermediate node N1 and the third intermediate node N3 can both be low, the potential of the second intermediate node N2 can be high, and the potential of the control node PD can be low. On this basis, the potential of the shift signal output via the shift output terminal NEXT and the potential of the drive signal output via the drive output terminal Nout can both be high.

(3) In phase T03, the potential of the input signal provided by the input terminal In (i.e., the enable signal terminal ESTV) can be low, the potential of the first clock signal provided by the first clock terminal CK can be high, and the potential of the second clock signal provided by the second clock terminal CKN can be low. Correspondingly, the P-type first transistor T1 and the P-type sixth transistor T6 can be controlled to be turned on, the N-type second transistor T2 and the N-type fourth transistor T4 can be controlled to be turned off, and the P-type third transistor T3, the P-type fifth transistor T5 and the N-type seventh transistor T7 can all be controlled to be turned off. In this way, the first power supply terminal V1 (i.e., the pull-up power supply terminal VGH1) can be in a conduction state with the first intermediate node N1, the second intermediate node N2 can be in a conduction state with the control node PD, the first power supply terminal V1 can be in a dis-conduction state with the second intermediate node N2, the second power supply terminal V2 (i.e., the pull-down power supply terminal VGL1) can be in a dis-conduction state with both the first intermediate node N1 and the third intermediate node N3, and the first intermediate node N1 and the third intermediate node N3 can both be in a dis-conduction state with the control node PD. Further, the high-potential power supply signal provided by the pull-up power supply terminal VGH1 can be transmitted to the first intermediate node N1 via the turned-on first transistor T1. That is, in this phase T03, a high-potential power supply signal can be written into the first intermediate node N1, while the potential of the control node PD can remain at the low potential before phase T03, and the potentials of the second intermediate node N2 and the third intermediate node N3 can also both remain low, for example, for a duration of one horizontal scanning period (i.e., 1H).

On the basis that the potential of the control node PD is low, the P-type eighth transistor T8, the P-type tenth transistor T10 and the P-type twelfth transistor T12 can be controlled to be turned on, and the N-type ninth transistor T9, the N-type eleventh transistor T11 and the N-type thirteenth transistor T13 can be controlled to be turned off. In this way, the third power supply terminal V3 (i.e., the pull-up power supply terminal VGH1) can be in a conduction state with the shift output terminal NEXT, the fourth power supply terminal V4 (i.e., the pull-down power supply terminal VGL1) can be in a dis-conduction state with the shift output terminal NEXT, the fifth power supply terminal V5 (i.e., the pull-up power supply terminal VGH2) can be in a conduction state with the drive output terminal Nout, and the sixth power supply terminal V6 (i.e., the pull-down power supply terminal VGL2) can be in a dis-conduction state with the drive output terminal Nout. Further, the high-potential power supply signal provided by the pull-up power supply terminal VGH1 can be transmitted to the shift output terminal NEXT via the turned-on eighth transistor T8, and the high-potential power supply signal provided by the pull-up power supply terminal VGH2 can be transmitted to the drive output terminal Nout sequentially via the turned-on twelfth transistor T12 and tenth transistor T10. That is, in this phase T03, a high-potential input signal can be transmitted to the input terminal In of other cascaded shift register units via the shift output terminal NEXT, and a high-potential drive signal can be transmitted to the pixel circuit via the drive output terminal Nout.

That is, in combination with Figs. 10 and 11, in this phase T03, the potential of the first intermediate node N1 can be high, the potentials of the second intermediate node N2 and the third intermediate node N3 can both be low, and the potential of the control node PD can be low. On this basis, the potential of the shift signal output via the shift output terminal NEXT and the potential of the drive signal output via the drive output terminal Nout can both be high.

(4) In phase T04, the potential of the input signal provided by the input terminal In (i.e., the enable signal terminal ESTV) can be low, the potential of the first clock signal provided by the first clock terminal CK can be low initially, and the potential of the second clock signal provided by the second clock terminal CKN can be high initially. Correspondingly, the P-type first transistor T1 and the P-type sixth transistor T6 can be controlled to be turned on, the N-type second transistor T2 and the N-type fourth transistor T4 can be controlled to be turned off, and the P-type third transistor T3, the P-type fifth transistor T5 and the N-type seventh transistor T7 can all be controlled to be turned on. In this way, the first power supply terminal V1 (i.e., the pull-up power supply terminal VGH1) can be in a conduction state with both the first intermediate node N1 and the second intermediate node N2, the first intermediate node N1, the second intermediate node N2 and the third intermediate node N3 can all be in a conduction state with the control node PD, and the second power supply terminal V2 (i.e., the pull-down power supply terminal VGL1) can be in a dis-conduction state with both the first intermediate node N1 and the third intermediate node N3. Further, the high-potential power supply signal provided by the pull-up power supply terminal VGH1 can be transmitted to the first intermediate node N1 via the turned-on first transistor T1 and to the second intermediate node N2 via the turned-on third transistor T3; the high-potential power supply signal transmitted to the first intermediate node N1 can be further transmitted to the control node PD via the turned-on fifth transistor T5; and the high-potential power supply signal transmitted to the second intermediate node N2 can be further transmitted to the control node PD via the turned-on sixth transistor T6. That is, in this phase T04, a high-potential power supply signal can be written into the first intermediate node N1 and the second intermediate node N2, and the high-potential power supply signal can be further controlled to be written into the control node PD, where the potential of the control node PD completes a shift rise from low to high, and the potential of the third intermediate node N3 can be high.

On the basis that the potential of the control node PD is high, the P-type eighth transistor T8, the P-type tenth transistor T10 and the P-type twelfth transistor T12 can be controlled to be turned off, and the N-type ninth transistor T9, the N-type eleventh transistor T11 and the N-type thirteenth transistor T13 can be controlled to be turned on. In this way, the fourth power supply terminal V4 (i.e., the pull-down power supply terminal VGL1) can be in a conduction state with the shift output terminal NEXT, the third power supply terminal V3 (i.e., the pull-up power supply terminal VGH1) can be in a dis-conduction state with the shift output terminal NEXT, the sixth power supply terminal V6 (i.e., the pull-down power supply terminal VGL2) can be in a conduction state with the drive output terminal Nout, and the fifth power supply terminal V5 (i.e., the pull-up power supply terminal VGH2) can be in a dis-conduction state with the drive output terminal Nout. Further, the low-potential power supply signal provided by the pull-down power supply terminal VGL1 can be transmitted to the shift output terminal NEXT via the turned-on ninth transistor T9, and the low-potential power supply signal provided by the pull-down power supply terminal VGL2 can be transmitted to the drive output terminal Nout sequentially via the turned-on thirteenth transistor T13 and eleventh transistor T11. That is, in this phase T04, a low-potential input signal can be transmitted to the input terminal In of other cascaded shift register units via the shift output terminal NEXT, and a low-potential drive signal can be transmitted to the pixel circuit via the drive output terminal Nout.

That is, in combination with Figs. 10 and 11, in this phase T04, the potentials of the first intermediate node N1, the second intermediate node N2 and the third intermediate node N3 can all be high, and the potential of the control node PD can be high. On this basis, the potential of the shift signal output via the shift output terminal NEXT and the potential of the drive signal output via the drive output terminal Nout can both be low. Thereafter, this phase T04 can be executed repeatedly. It can also be seen from Figs. 10 and 11 that the falling edges of the shift signal and the drive signal output by the shift register unit provided in the embodiments of the present disclosure are free of steps, resulting in good output reliability.

It can be known from the above description that phases T02 and T03 may correspond to the first phase shown in Fig. 9, and phases T01 and T04 may correspond to the second phase shown in Fig. 9.

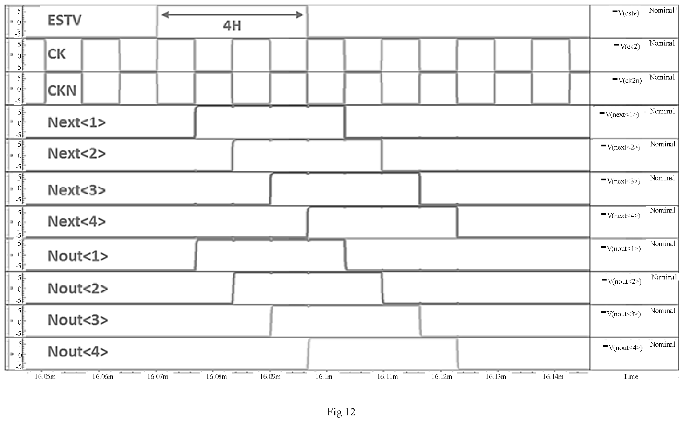

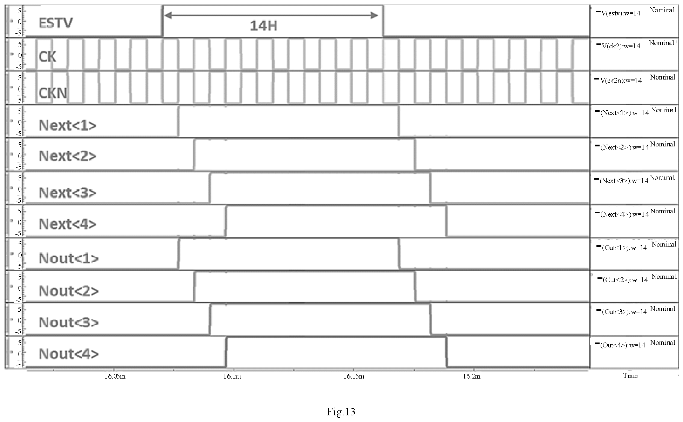

Optionally, on the basis of Figs. 10 and 11, Figs. 12 and 13 also schematically show the simulation timing diagrams of the signals output by the four stages of cascaded shift register units via the shift output terminal NEXT and the drive output terminal Nout respectively under the control of input signals with different widths. The width of the input signal may refer to the duration during which the input signal is at an effective potential (e.g., high potential). The width shown in Fig. 12 is 4H, and the width shown in Fig. 13 is 14H. In addition, in Figs. 12 and 13, the shift output terminals Next of the four stages of cascaded shift register units are labeled as Next<1>, Next<2>, Next<3> and Next<4> respectively, and the drive output terminals Nout are labeled as Nout<1>, Nout<2>, Nout<3> and Nout<4> respectively.

It can be seen from Figs. 12 and 13 that under the control of input signals with different widths, the shift register unit can output signals with corresponding widths via the shift output terminal NEXT and the drive output terminal Nout respectively. Thus, the signal width of the input signal can be flexibly adjusted according to requirements to output signals with the required widths via the shift output terminal NEXT and the drive output terminal Nout respectively. For example, it can support the output of N-type gate drive signals GateN of the even stages via the drive output terminal Nout. Further, it can meet the requirements of high-frequency PWM driving.

Optionally, it can be known from the above description that the shift register unit provided in the embodiments of the present disclosure can also support the partial-refresh function. On this basis, taking the structure shown in Fig. 8 as an example, Fig. 14 schematically shows a partial-refresh timing diagram on the basis of Fig. 10.

First, it can be seen from Fig. 8 that the display area A of the display panel shown is divided into three areas: a first display area A1 and two second display areas A2-1 and A2-2. The refresh frequency of the two second display areas A2-1 and A2-2 is 1 Hz, and the refresh frequency of the first display area A1 is 120 Hz. That is, the two second display areas A2-1 and A2-2 are low-frequency refresh areas, and the first display area A1 is a high-frequency refresh area.

Second, on the basis of Fig. 8, it can be further seen from Fig. 14 that for the high-frequency refresh area (e.g., the first display area A1), the fifth power supply terminal V5 (i.e., the pull-up power supply terminal VGH2) can continuously provide a high-potential fifth power supply signal, so that a high-potential drive signal is output via the drive output terminal Nout. For the low-frequency refresh areas (e.g., the second display areas A2-1 and A2-2), the fifth power supply signal provided by the fifth power supply terminal V5 can be switched from a high potential to a low potential, for example, to the low potential of the power supply signal provided by the pull-down power supply terminal VGL2, so that a low-potential drive signal is continuously output via the drive output terminal Nout. That is, as shown in Figs. 8 and 14, the shift register unit can output a low-potential drive signal to the low-refresh second display areas A2-1 and A2-2 and a high-potential drive signal to the high-refresh first display area A1 via the drive output terminal Nout, control the pixels in the second display areas A2-1 and A2-2 to emit light in response to the low-potential drive signal, and control the pixels in the first display area A1 to emit light in response to the high-potential drive signal, realizing low-frequency refresh and high-frequency refresh.

It can be understood that in Fig. 14, Nout<1> may refer to the drive output terminal Nout of the first-stage shift register unit connected to the first row of pixels; Next<1> may refer to the shift output terminal NEXT of the first-stage shift register unit connected to the first row of pixels; Next<N> may refer to the shift output terminal NEXT of the N-th-stage shift register unit connected to the N-th row of pixels; Nout<N+1> may refer to the drive output terminal Next of the (N+1)th-stage shift register unit connected to the (N+1)th row of pixels; and Next<N+1> may refer to the shift output terminal NEXT of the (N+1)th-stage shift register unit connected to the (N+1)-th row of pixels. N may be an integer greater than 0 and less than the number of pixel rows.

It can also be understood that since the driving method of the shift register unit can achieve basically the same technical effects as the shift register unit described in the previous embodiments, the technical effects of the driving method of the shift register unit will not be described repeatedly here for the sake of brevity.

In some embodiments, the first clock terminal CK is reused as the second clock terminal CKN; the first clock signal provided by the first clock terminal CK is the same as the second clock signal CKN provided by the second clock terminal.

In some embodiments, the shift register unit further includes a reset circuit 07, which is respectively connected to the reset signal terminal CX, the first power supply terminal V1 and the control node PD, and is configured to control on or off between the first power supply terminal V1 and the control node PD in response to the reset signal provided by the reset signal terminal CX; the method includes: in the reset phase, the reset circuit 07 controls the first power supply terminal V1 to be in a conduction state with the control node PD in response to the reset signal provided by the reset signal terminal CX.

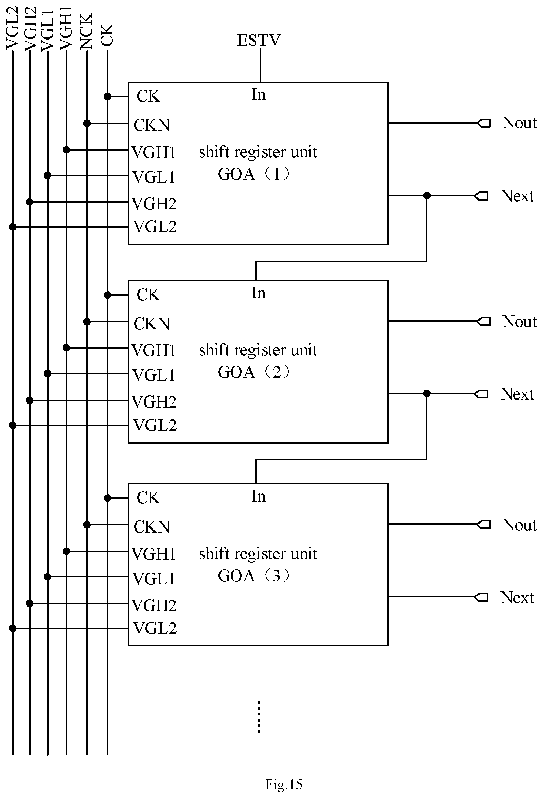

The embodiments of the present disclosure also provide a display driving circuit. As shown in Fig. 15, the display driving circuit includes a plurality of cascaded shift register units (i.e., GOA units) as shown in any one of Figs. 1 to 7.

It can be understood from the above description and Fig. 15 that each GOA unit is connected to the input terminal In of other cascaded GOA units via the shift output terminal NEXT, and the input terminal In of the first GOA unit GOA (1) can be in a conduction state with the enable signal terminal ESTV to realize cascaded driving. The drive output terminal Nout of each GOA unit can be in a conduction state with the pixels in the display panel to realize scan driving. In addition, each GOA unit can also be connected to the clock terminals CK and CKN respectively. Moreover, in a power supply scenario using dual VGHs and dual VGLs, each GOA unit can also be connected to two pull-up power supply terminals VGH1 and VGH2 and two pull-down power supply terminals VGL1 and VGL2 respectively.

It can be understood that when the GOA unit transmits an N-type gate drive signal GateN via the drive output terminal Nout, the GOA unit may also be referred to as a GateN GOA unit, and the display driving circuit including the GateN GOA unit may also be referred to as a gate driving circuit.

Optionally, when the fifth power supply terminal V5 (i.e., the pull-up power supply terminal VGH2) connected to each GOA unit is an AC power supply terminal, at least two GOA units may be connected to different fifth power supply terminals V5. That is, multiple groups of VGH2 can be set for connection to the cascaded multiple GOA units, not limited to two or three groups of VGH2. In this way, compared with setting one group of VGH2 for connection to multiple GOA units as shown in Fig. 15, the voltage drop of the power supply signals provided by each group of VGH2 can be reduced, so that the GOA units connected to different VGH2 can all reliably receive the power supply signals provided by VGH2. That is, the cooperation with multiple groups of VGH2 can ensure the output integrity of the drive signal and meet the requirements of the partial-refresh function.

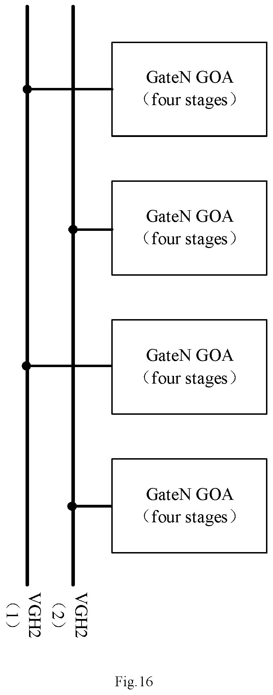

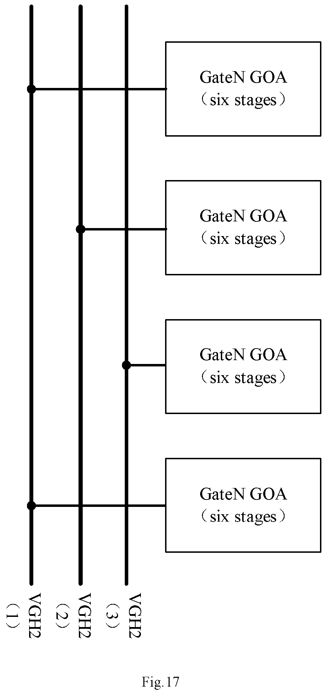

For example, referring to Fig. 16, two groups of VGH2 (1) and VGH2 (2) are provided in the display driving circuit shown; referring to Fig. 17, three groups of VGH2 (1), VGH2 (2) and VGH2 (3) are provided in the display driving circuit shown. In addition, it can also be seen from Figs. 16 and 17 that multiple groups of VGH2 can also be set to be alternately connected to multiple GOA units. For example, in Fig. 16, every four stages of GOA units form a group of GOA units, and adjacent two groups of GOA units are alternately connected to the two groups of VGH2 (1) and VGH2 (2) in a one-to-one correspondence. In Fig. 17, every six stages of GOA units form a group of GOA units, and adjacent three groups of GOA units are alternately connected to three groups of VGH2 (1), VGH2 (2) and VGH2 (3) in a one-to-one correspondence. The GOA units shown in Figs. 16 and 17 are all GateN GOA units.

Of course, the above examples are only schematic illustrations. For example, the number of GOA units connected to each group of VGH2 is not limited, and the number of groups of VGH2 provided is not limited. In addition, in some other embodiments, the setting of multiple groups of VGH2 is not limited; for example, CK and/or CKN can also be set as multiple groups.

It can be understood that since the display driving circuit can achieve basically the same technical effects as the shift register unit described in the previous embodiments, the technical effects of the display driving circuit will not be described repeatedly here for the sake of brevity.

The embodiment of the present application also provides a display device. As shown in Fig. 18, the display device includes a display panel 10 and the display driving circuit 00 as shown in any one of Figs. 15 to 17.

The display panel 10 may include a plurality of pixels (not shown in Fig. 18). The display driving circuit 00 may be connected to the plurality of pixels via the drive output terminal Nout, and is configured to transmit drive signals (e.g., gate drive signals) to the plurality of pixels to drive the plurality of pixels to emit light.

Optionally, the display device described in the embodiments of the present disclosure may be any product or component with a display function, such as an active-matrix organic light-emitting diode (AMOLED) display device, an organic light-emitting diode (OLED) display device, and a liquid crystal display device.

The AMOLED display device has the advantages of low power consumption, a wide operating temperature range, low cost, high contrast, a wide viewing angle, a wide color gamut and a thin display panel, and can realize flexible display, gradually becoming the crown of the next generation of displays. The OLED display device can meet the high performance and large capacity requirements of display equipment in most of today's information age, can be used for indoor and outdoor lighting, can be used as wallpaper decorations, can be made into foldable electronic newspapers, and can also be applied to portable electronic products such as mobile phones, tablet computers and wearable electronic devices.

It can be understood that since the display device can achieve basically the same technical effects as the shift register unit described in the previous embodiments, the technical effects of the display device will not be described repeatedly here for the sake of brevity.

It should be noted that the terms used in some parts of the embodiments of the present disclosure are only for explaining the embodiments and are not intended to limit the present disclosure. Unless otherwise defined, the technical or scientific terms used in the embodiments of the present disclosure shall have the ordinary meanings understood by those skilled in the art to which the present disclosure belongs.

For example, the terms "first", "second", "third" and similar terms used in the specification and claims of the patent application of the present disclosure do not indicate any order, quantity or importance, but are only used to distinguish different components.

Similarly, the terms "a" or "an" and similar terms do not indicate a quantity limit, but indicate the presence of at least one.

The terms "include" or "comprise" and similar terms mean that the elements or objects appearing before "include" or "comprise" cover the elements or objects listed after "include" or "comprise" and their equivalents, and do not exclude other elements or objects.

Terms such as "upper", "lower", "left" or "right" are only used to indicate a relative positional relationship, and when the absolute position of the described object changes, the relative positional relationship may also change accordingly. "Connection" or "coupling" refers to electrical connection.

"And/or" means that three relationships may exist; for example, A and/or B may mean: A exists alone, both A and B exist, and B exists alone. The symbol "/" generally indicates that the associated objects before and after are in an "or" relationship.

The above are only optional embodiments of the present disclosure and are not intended to limit the present disclosure. Any modification, equivalent replacement, improvement, etc. made within the spirit and principle of the present disclosure shall be included in the protection scope of the present disclosure.

## Claims

1. A shift register unit, comprising:
an input circuit connected to an input terminal, a first clock terminal, a second clock terminal, a first power supply terminal, a second power supply terminal and a control node, and configured to control on or off between the first power supply terminal and the control node and on or off between the second power supply terminal and the control node in response to an input signal provided by the input terminal, a first clock signal provided by the first clock terminal and a second clock signal provided by the second clock terminal, wherein the first power supply terminal and the second power supply terminal are in a conduction state with the control node in different time periods respectively;
a first output circuit connected to the control node, a third power supply terminal, a fourth power supply terminal and a shift output terminal, and configured to control on or off between the third power supply terminal and the shift output terminal and on or off between the fourth power supply terminal and the shift output terminal in response to a potential of the control node, wherein the third power supply terminal and the fourth power supply terminal are in a conduction state with the control node in different time periods respectively;
a second output circuit connected to the control node, a fifth power supply terminal, a sixth power supply terminal and a drive output terminal, and configured to control on or off between the fifth power supply terminal and the drive output terminal and on or off between the sixth power supply terminal and the drive output terminal in response to the potential of the control node, wherein the third power supply terminal and the fourth power supply terminal are in a conduction state with the control node in different time periods respectively.

2. The shift register unit according to claim 1, wherein the input circuit comprises:
a first input sub-circuit connected to the input terminal, the first power supply terminal, the second power supply terminal and a first intermediate node respectively, and configured to control on or off between the first power supply terminal and the first intermediate node and on or off between the second power supply terminal and the first intermediate node in response to the input signal, wherein the first power supply terminal and the second power supply terminal are in a conduction state with the first intermediate node in different time periods respectively;
a second input sub-circuit connected to the input terminal, the first clock terminal, the second clock terminal, the first intermediate node, the first power supply terminal, the second power supply terminal and the control node, and configured to control on or off between the first intermediate node and the control node in response to the first clock signal, control on or off between the first power supply terminal and the control node in response to the first clock signal and the input signal, and control on or off between the second power supply terminal and the control node in response to the second clock signal and the input signal.

3. The shift register unit according to claim 2, wherein the first input sub-circuit comprises a first transistor and a second transistor, the first transistor is a first-type transistor, and the second transistor is a second-type transistor;
a gate of the first transistor is connected to the input terminal, a first electrode of the first transistor is connected to the first power supply terminal, and a second electrode of the first transistor is connected to the first intermediate node;
a gate of the second transistor is connected to the input terminal, a first electrode of the second transistor is connected to the second power supply terminal, and a second electrode of the second transistor is connected to the first intermediate node.

4. The shift register unit according to claim 2, wherein the second input sub-circuit comprises:
a first input unit connected to the first clock terminal, the first power supply terminal and a second intermediate node, and configured to control on or off between the first power supply terminal and the second intermediate node in response to the first clock signal;
a second input unit connected to the input terminal, the second power supply terminal and a third intermediate node, and configured to control on or off between the second power supply terminal and the third intermediate node in response to the input signal;
a third input unit connected to the first clock terminal, the second clock terminal, the input terminal, the first intermediate node, the second intermediate node, the third intermediate node and the control node, and configured to control on or off between the first intermediate node and the control node in response to the first clock signal, control on or off between the second intermediate node and the control node in response to the input signal, and control on or off between the third intermediate node and the control node in response to the second clock signal.

5. The shift register unit according to claim 4, wherein the first input unit comprises a third transistor, the second input unit comprises a fourth transistor, the third input unit comprises a fifth transistor, a sixth transistor and a seventh transistor, and the third transistor, the fifth transistor and the sixth transistor are first-type transistors, and the fourth transistor and the seventh transistor are second-type transistors;
a gate of the third transistor is connected to the first clock terminal, a first electrode of the third transistor is connected to the first power supply terminal, and a second electrode of the third transistor is connected to the second intermediate node;
a gate of the fourth transistor is connected to the input terminal, a first electrode of the fourth transistor is connected to the second power supply terminal, and a second electrode of the fourth transistor is connected to the third intermediate node;
a gate of the fifth transistor is connected to the first clock terminal, a first electrode of the fifth transistor is connected to the first intermediate node, and a second electrode of the fifth transistor is connected to the control node;
a gate of the sixth transistor is connected to the input terminal, a first electrode of the sixth transistor is connected to the second intermediate node, and a second electrode of the sixth transistor is connected to the control node;
a gate of the seventh transistor is connected to the second clock terminal, a first electrode of the seventh transistor is connected to the third intermediate node, and a second electrode of the seventh transistor is connected to the control node.

6. The shift register unit according to claim 4, wherein the first clock terminal is reused as the second clock terminal, and the first clock terminal and the second clock terminal are input with the same clock signal.

7. The shift register unit according to claim 6, wherein the first input unit comprises a third transistor, the second input unit comprises a fourth transistor, the third input unit comprises a fifth transistor, a sixth transistor and a seventh transistor, the third transistor, the fifth transistor, the sixth transistor and the seventh transistor are first-type transistors, and the fourth transistor is a second-type transistor;
a gate of the third transistor is connected to the first clock terminal, a first electrode of the third transistor is connected to the first power supply terminal, and a second electrode of the third transistor is connected to the second intermediate node;
a gate of the fourth transistor is connected to the input terminal, a first electrode of the fourth transistor is connected to the second power supply terminal, and a second electrode of the fourth transistor is connected to the third intermediate node;
a gate of the fifth transistor is connected to the first clock terminal, a first electrode of the fifth transistor is connected to the first intermediate node, and a second electrode of the fifth transistor is connected to the control node;
a gate of the sixth transistor is connected to the input terminal, a first electrode of the sixth transistor is connected to the second intermediate node, and a second electrode of the sixth transistor is connected to the control node;
a gate of the seventh transistor is connected to the first clock terminal, a first electrode of the seventh transistor is connected to the third intermediate node, and a second electrode of the seventh transistor is connected to the control node.

8. The shift register unit according to claim 1, wherein the first output circuit comprises an eighth transistor and a ninth transistor, the eighth transistor is a first-type transistor, and the ninth transistor is a second-type transistor;
a gate of the eighth transistor is connected to the control node, a first electrode of the eighth transistor is connected to the third power supply terminal, and a second electrode of the eighth transistor is connected to the shift output terminal;
a gate of the ninth transistor is connected to the control node, a first electrode of the ninth transistor is connected to the fourth power supply terminal, and a second electrode of the ninth transistor is connected to the shift output terminal.

9. The shift register unit according to any one of claims 1 to 7, wherein the third power supply terminal is commonly used with the first power supply terminal, and/or the fourth power supply terminal is commonly used with the second power supply terminal.

10. The shift register unit according to claim 1, wherein the second output circuit comprises a tenth transistor and an eleventh transistor, the tenth transistor is a first-type transistor, and the eleventh transistor is a second-type transistor;
a gate of the tenth transistor is connected to the control node, a first electrode of the tenth transistor is connected to the fifth power supply terminal, and a second electrode of the tenth transistor is connected to the drive output terminal;
a gate of the eleventh transistor is connected to the control node, a first electrode of the eleventh transistor is connected to the sixth power supply terminal, and a second electrode of the eleventh transistor is connected to the drive output terminal.

11. The shift register unit according to claim 10, wherein the second output circuit further comprises a twelfth transistor connected in series between the fifth power supply terminal and the tenth transistor, and a thirteenth transistor connected in series between the sixth power supply terminal and the eleventh transistor; the twelfth transistor is of the same type as the tenth transistor, and the thirteenth transistor is of the same type as the eleventh transistor;
a gate of the twelfth transistor is connected to the control node, a first electrode of the twelfth transistor is connected to the fifth power supply terminal, and a second electrode of the twelfth transistor is connected to a first electrode of the tenth transistor;
a gate of the thirteenth transistor is connected to the control node, a first electrode of the thirteenth transistor is connected to the sixth power supply terminal, and a second electrode of the thirteenth transistor is connected to a first electrode of the eleventh transistor.

12. The shift register unit according to claim 11, wherein the tenth transistor and the twelfth transistor connected in series have different channel width-to-length ratios;
and/or
the eleventh transistor and the thirteenth transistor connected in series have different channel width-to-length ratios.

13. The shift register unit according to claim 12, wherein the channel width-to-length ratio of the tenth transistor is greater than that of the twelfth transistor;
the channel width-to-length ratio of the eleventh transistor is greater than that of the thirteenth transistor.

14. The shift register unit according to claim 10, further comprising:
a drive enhancement circuit connected between the control node and the second output circuit, and configured to transmit the potential of the control node to the second output circuit after performing at least one enhancement process on the potential of the control node.

15. The shift register unit according to claim 14, wherein the drive enhancement circuit comprises one or more inverters connected in series;
each of the one or more inverters comprises a fourteenth transistor and a fifteenth transistor connected in series between the first power supply terminal and the second power supply terminal;
the fourteenth transistor is a first-type transistor, and the fifteenth transistor is a second-type transistor.

16. The shift register unit according to claim 1, wherein the second output circuit is connected to the shift output terminal so as to be connected to the control node through the first output circuit;
the second output circuit is configured to control on or off between the fifth power supply terminal and the drive output terminal and the on or off between the sixth power supply terminal and the drive output terminal in response to the potential of the shift output terminal.

17. The shift register unit according to claim 16, wherein the second output circuit comprises an eighteenth transistor and a nineteenth transistor;
a gate of the eighteenth transistor is connected to the shift output terminal, a first electrode of the eighteenth transistor is connected to the fifth power supply terminal, and a second electrode of the eighteenth transistor is connected to the drive output terminal; a gate of the nineteenth transistor is connected to the shift output terminal, a first electrode of the nineteenth transistor is connected to the sixth power supply terminal, and a second electrode of the nineteenth transistor is connected to the drive output terminal.

18. The shift register unit according to claim 16, further comprising:
an output enhancement circuit connected between the shift output terminal and the second output circuit, and configured to transmit the potential of the shift output terminal to the second output circuit after performing at least one enhancement process on the potential of the shift output terminal.

19. The shift register unit according to claim 18, wherein the output enhancement circuit comprises one or at least two inverters connected in series;
each of the one or at least two inverters comprises a twentieth transistor and a twenty-first transistor connected in series between the first power supply terminal and the second power supply terminal; the twentieth transistor is a first-type transistor, and the twenty-first transistor is a second-type transistor.

20. The shift register unit according to any one of claims 10 to 19, wherein the first to fourth power supply terminals and the sixth power supply terminal are all DC power supply terminals, and the fifth power supply terminal is a DC power supply terminal or an AC power supply terminal.

21. The shift register unit according to claim 20, wherein the drive output terminal is configured to be connected to pixels in display areas of a display panel for transmitting a drive signal to the pixels to drive the pixels to emit light, and the display areas comprise a first display area and a second display area, a refresh frequency of the first display area is higher than a refresh frequency of the second display area;
when driving the pixels in the first display area to emit light, the potential of a fifth power supply signal provided by the fifth power supply terminal is higher than the potential of the fifth power supply signal provided by the fifth power supply terminal when driving the pixels in the second display area to emit light.

22. The shift register unit according to claim 21, wherein when driving the pixels in the second display area to emit light, the potential of the fifth power supply signal provided by the fifth power supply terminal is higher than the potential of a second power supply signal provided by the second power supply terminal.

23. The shift register unit according to any one of claims 3 to 8, 10 to 15 and 19, wherein in the shift register unit, the first-type transistor is a P-type transistor, and the second-type transistor is an N-type transistor.

24. The shift register unit according to any one of claims 1 to 7, further comprising a storage capacitor connected between the first power supply terminal and the control node.

25. The shift register unit according to any one of claims 1 to 7, further comprising:
a reset circuit connected to a reset signal terminal, the first power supply terminal and the control node, and configured to control on or off between the first power supply terminal and the control node in response to a reset signal provided by the reset signal terminal.

26. The shift register unit according to claim 25, wherein the reset circuit comprises a sixteenth transistor and a seventeenth transistor;
a gate of the sixteenth transistor is connected to the reset signal terminal, a first electrode of the sixteenth transistor is connected to the first power supply terminal, and a second electrode of the sixteenth transistor is connected to a first electrode of the seventeenth transistor; a gate of the seventeenth transistor is connected to the reset signal terminal, and a second electrode of the seventeenth transistor is connected to the control node.

27. A driving method for a shift register unit, used for driving the shift register unit according to any one of claims 1 to 26; wherein the method comprises:
a first phase in which an input circuit controls a first power supply terminal to be in a dis-conduction state with a control node and controls a second power supply terminal to be in a dis-conduction state with the control node in response to an input signal provided by an input terminal, a first clock signal provided by a first clock terminal and a second clock signal provided by a second clock terminal; a first output circuit controls a third power supply terminal to be in a conduction state with a shift output terminal and controls a fourth power supply terminal to be in a dis-conduction state with the shift output terminal in response to the potential of the control node; a second output circuit controls a fifth power supply terminal to be in a conduction state with a drive output terminal and control a sixth power supply terminal to be in a dis-conduction state with the drive output terminal in response to the potential of the control node;
a second phase in which the input circuit controls the first power supply terminal to be in a conduction state with the control node and controls the second power supply terminal to be in a dis-conduction state with the control node in response to the input signal, the first clock signal and the second clock signal; the first output circuit controls the third power supply terminal to be in a dis-conduction state with the shift output terminal and controls the fourth power supply terminal to be in a dis-conduction state with the shift output terminal in response to the potential of the control node; the second output circuit controls the fifth power supply terminal to be in a dis-conduction state with the drive output terminal and controls the sixth power supply terminal to be in a conduction state with the drive output terminal in response to the potential of the control node.

28. The driving method for a shift register unit according to claim 27, wherein the first clock terminal is reused as the second clock terminal; the first clock signal provided by the first clock terminal is the same as the second clock signal provided by the second clock terminal.

29. The driving method for a shift register unit according to claim 27 or 28, wherein the shift register unit further comprises a reset circuit connected to a reset signal terminal, the first power supply terminal and the control node, and configured to control on or off between the first power supply terminal and the control node in response to a reset signal provided by the reset signal terminal;
the method comprises:
a reset phase, in which the reset circuit controls the first power supply terminal to be in a conduction state with the control node in response to a reset signal provided by the reset signal terminal.

30. A display driving circuit, comprising a plurality of cascaded shift register units according to any one of claims 1 to 26.

31. The display driving circuit according to claim 30, wherein in case that a fifth power supply terminal connected to each of the plurality of shift register units is an alternate current power supply terminal, at least two of the plurality of shift register units are connected to different fifth power supply terminals.

32. A display device, comprising a display panel and the display driving circuit according to claim 30 or 31; the display panel comprises a plurality of pixels;
the display driving circuit is connected to a plurality of pixels through a drive output terminal, and configured to transmit a drive signal to the plurality of pixels to drive the plurality of pixels to emit light.
